# EUROPEAN PATENT APPLICATION

(11) **EP 3 846 509 A1**
(43) Date of publication of application: **07.07.2021**
(21) Application number: 19856203.5
(22) Date of filing: 01.08.2019
(51) Int. Cl.: H04W 4/40

(54) **METHOD AND DEVICE FOR NODE FOR WIRELESS COMMUNICATION**

(30) Priority: 31.08.2018 CN 201811009145
(71) Applicant: SHANGHAI LANGBO COMMUNICATION TECHNOLOGY COMPANY LIMITED, Shanghai 201206 (CN)
(72) Inventor: LIU, Zheng, Shanghai 201206 (CN); ZHANG, Xiaobo, Shanghai 201206 (CN); YANG, Lin, Shanghai 201206 (CN)
(74) Representative: Zhang, Fan
(86) International application number: PCT/CN2019/098843
(87) International publication number: WO 2020/042862

(57) **Abstract**

The present application discloses a method and device for a communication node for wireless communication. The method comprises: firstly, a communication node sending first information, wherein the first information is used to indicate K REs; and then respectively sending K modulation symbols on the K REs. A time domain resource occupied by the K REs comprises M multi-carrier symbols. A first multi-carrier symbol is one of the M multi-carrier symbols. K1 modulation symbols comprise all modulation symbols in the K modulation symbols mapped to the first multi-carrier symbol. The K modulation symbols belong to a target modulation symbol sequence. The first K2 modulation symbols in the target modulation symbol sequence comprise the K1 modulation symbols. A time domain position of the first multi-carrier symbol in the M multi-carrier symbols is related to at least one of subcarrier spacing of subcarriers occupied by the K REs and M. The present application improves link performance.

## Description

### TECHNICAL FIELD

The present disclosure relates to transmission methods and devices in wireless communication systems, and in particular to a scheme and a device for multiple Numerologies in wireless communications.

### BACKGROUND

Application scenarios of future wireless communication systems are becoming increasingly diversified, and different application scenarios have different performance demands on systems. In order to meet different performance requirements of various application scenarios, the 3^{rd} Generation Partner Project (3GPP) Radio Access Network (RAN) #72 plenary session decided to conduct the study of New Radio (NR), or what is called fifth Generation (5G). The work Item (WI) of NR was approved at the 3GPP RAN #75 plenary session to standardize the NR.

In response to rapidly growing Vehicle-to-Everything (V2X) traffic, 3GPP has started standards setting and research work under the framework of NR. Currently, 3GPP has completed planning work targeting 5G V2X requirements and has included these requirements into standard TS22.886, where 3GPP identifies and defines 4 major Use Case Groups, covering cases of Vehicles Platooning, supporting Extended Sensors, Advanced Driving and Remote Driving. At 3GPP RAN #80 Plenary Session, the technical Study Item (SI) of NR V2X was approved.

### SUMMARY

Compared with the existing LTE systems, 5G NR has an outstanding feature of supporting more flexible Numerologies, which includes Subcarrier Spacing (SCS) and Cyclic Prefix (CP), and more flexible frame structures, such as of mini-slot, sub-slot and slot aggregation. With such flexible numerologies and frame structures, various new business requirements will be better satisfied, especially in highly diversified vertical industries. Due to distributed feature of V2X traffic, strength of received signals (may include both useful signals and interference signals) varies greatly, therefore, Automatic Gain Control(AGC) is necessary for the receiver to reduce quantizing noise and avoid nonlinearity of devices. LTE V2X system is single-numerology-based, namely, 15kHz SCS, normal length of CP and 1 ms of subframe length. A first multicarrier symbol is generally considered as AGC of the receiver in implementation, while this design may not be well adapted to 5G NR V2X network that supports multiple numerologies. In addition, due to inconsistency of transmission timing in Sidelink, a GAP may be needed at the beginning or ending stage of the transmission to avoid collisions, and the existence of the GAP may result in that new designs are needed to adapt to the 5G NR V2X network with different numerologies.

In view of the problem of supporting multiple numerologies in NR V2X, the present disclosure discloses a solution. It should be noted that the embodiments of a User Equipment (UE) in the present disclosure and the characteristics of the embodiments may be applied to a base station if no conflict is incurred, and vice versa. The embodiments of the present disclosure and the characteristics of the embodiments may be mutually combined if no conflict is incurred. In particular, the solution disclosed in the present disclosure can be used in NR V2X communications, and also in communications between the base station and the UE.

The present disclosure provides a method in a first communication node for wireless communications, comprising:
transmitting first information, the first information being used for indicating K REs, time-domain resources occupied by the K REs comprising M multicarrier symbols, K and M being positive integers greater than 1, the first information being transmitted via an air interface; and
transmitting K modulation symbols respectively on the K REs;
herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of a Subcarrier Spacing(SCS) of a subcarrier occupied by the K REs or M, or the first information is used for indicating a time-domain position of the first multicarrier symbol among the M multicarrier symbols.

In one embodiment, by adjusting a time-domain position of the first multicarrier symbol among the M multicarrier symbols to realize a configurable resource mapping method and starting symbol of the target modulation-symbol sequence can reduce impact of increasing bit error rate incurred by AGC or avoid transmission failure.

In one embodiment, a number of multicarrier symbols occupied by AGC or GAP is determined according to an SCS of a subcarrier occupied by the K REs, so as to adjust a mapping starting mode of the target modulation-symbol sequence, realizing the balance between decoding delay and link performance.

In one embodiment, supporting the target modulation-symbol sequence to start resource mapping on multicarrier symbols other than a starting multicarrier symbol can avoid the loss of information bits in the system code incurred by the AGC, thus improving decoding performance.

According to one aspect of the present disclosure, the above method is characterized in also comprising:
transmitting a first radio signal;
herein, an end time for transmitting the first radio signal is not later than a start time for transmitting the K modulation symbols, and a time interval between an end time for transmitting the first radio signal and a start time for transmitting the K modulation symbols is a first time interval; for a given SCS of a subcarrier occupied by the K REs and given M, a time-domain position of the first multicarrier symbol among the M multicarrier symbols is related to a time length of the first time interval.

In one embodiment, when a time length of the first time interval is short enough, and the first radio signal and the K modulation symbols are for a same receiver, the result of same AGC can be shared, thus avoiding waste of resources incurred by AGC.

According to one aspect of the present disclosure, the above method is characterized in that when the first multicarrier symbol is a multicarrier symbol other than an earliest multicarrier symbol in time domain among the M multicarrier symbols, any multicarrier symbol occupied by K3 RE(s) among the K REs in time domain is not earlier than the first multicarrier symbol, K3 being a positive integer less than K; and at least one of K3 or a number of multicarrier symbol(s) occupied by the K3 RE(s) is used for determining a number of bit(s) comprised in the first bit block.

According to one aspect of the present disclosure, the above method is characterized in that for given the K REs and given M, a number of modulation symbols comprised in the target modulation-symbol sequence is related to a time-domain position of the first multicarrier symbol among the M multicarrier symbols.

According to one aspect of the present disclosure, the above method is characterized in that when the first multicarrier symbol is a multicarrier symbol other than an earliest multicarrier symbol in time domain among the M multicarrier symbols, there exist a first RE and a second RE among the K REs, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a modulation symbol occupying the first RE among the K modulation symbols is the same as a modulation symbol occupying the second RE among the K modulation symbols.

According to one aspect of the present disclosure, the above method is characterized in that when the first multicarrier symbol is a multicarrier symbol other than an earliest multicarrier symbol in time domain among the M multicarrier symbols, any multicarrier symbol occupied by K4 RE(s) among the K REs in time domain is earlier than the first multicarrier symbol, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

According to one aspect of the present disclosure, the above method is characterized in that the M multicarrier symbols are indexed in order of time, an index value of the first multicarrier symbol among the M multicarrier symbols is one of X1 candidate index value(s);
for given M, an SCS of a subcarrier occupied by the K REs is one of X2 candidate SCS(s), for each of the X2 candidate SCS(s), there exists one of the X1 candidate index value(s) that corresponds to the candidate SCS;
or for a given SCS of a subcarrier occupied by the K REs, M is one of X3 candidate positive integer(s), for each of the X3 candidate positive integer(s), there exists one of the X1 candidate index value(s) that corresponds to the candidate positive integer.

The present disclosure provides a method in a second communication node for wireless communications, comprising:
receiving first information, the first information being used for indicating K REs, time-domain resources occupied by the K REs comprising M multicarrier symbols, K and M being positive integers greater than 1, the first information being transmitted via an air interface; and
receiving K modulation symbols respectively on the K REs;
herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

According to one aspect of the present disclosure, the above method is characterized in also comprising:
receiving a first radio signal;
herein, an end time for transmitting the first radio signal is not later than a start time for transmitting the K modulation symbols, and a time interval between an end time for transmitting the first radio signal and a start time for transmitting the K modulation symbols is a first time interval; for a given SCS of a subcarrier occupied by the K REs and given M, a time-domain position of the first multicarrier symbol among the M multicarrier symbols is related to a time length of the first time interval.

According to one aspect of the present disclosure, the above method is characterized in that when the first multicarrier symbol is a multicarrier symbol other than an earliest multicarrier symbol in time domain among the M multicarrier symbols, any multicarrier symbol occupied by K3 RE(s) among the K REs in time domain is not earlier than the first multicarrier symbol, K3 being a positive integer less than K; at least one of K3 or a number of multicarrier symbol(s) occupied by the K3 RE(s) is used for determining a number of bit(s) comprised in the first bit block.

According to one aspect of the present disclosure, the above method is characterized in that for given the K REs and given M, a number of modulation symbols comprised in the target modulation-symbol sequence is related to a time-domain position of the first multicarrier symbol among the M multicarrier symbols.

According to one aspect of the present disclosure, the above method is characterized in that when the first multicarrier symbol is a multicarrier symbol other than an earliest multicarrier symbol in time domain among the M multicarrier symbols, there exist a first RE and a second RE among the K REs, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a modulation symbol occupying the first RE among the K modulation symbols is the same as a modulation symbol occupying the second RE among the K modulation symbols.

According to one aspect of the present disclosure, the above method is characterized in that when the first multicarrier symbol is a multicarrier symbol other than an earliest multicarrier symbol in time domain among the M multicarrier symbols, any multicarrier symbol occupied by K4 RE(s) among the K REs in time domain is earlier than the first multicarrier symbol, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

According to one aspect of the present disclosure, the above method is characterized in that the M multicarrier symbols are indexed in order of time, an index value of the first multicarrier symbol among the M multicarrier symbols is one of X1 candidate index value(s);
for given M, an SCS of a subcarrier occupied by the K REs is one of X2 candidate SCS(s), for each of the X2 candidate SCS(s), there exists one of the X1 candidate index value(s) that corresponds to the candidate SCS;
or for a given SCS of a subcarrier occupied by the K REs, M is one of X3 candidate positive integer(s), for each of the X3 candidate positive integer(s), there exists one of the X1 candidate index value(s) that corresponds to the candidate positive integer.

The present disclosure provides a first communication node for wireless communications, comprising:
a first transmitter, transmitting first information, the first information being used for indicating K REs, time-domain resources occupied by the K REs comprising M multicarrier symbols, K and M being positive integers greater than 1, the first information being transmitted via an air interface; and
a second transmitter, transmitting K modulation symbols respectively on the K REs;
herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

The present disclosure provides a second communication node for wireless communications, comprising:
a first receiver, receiving first information, the first information being used for indicating K REs, time-domain resources occupied by the K REs comprising M multicarrier symbols, K and M being positive integers greater than 1, the first information being transmitted via an air interface; and
a second receiver, receiving K modulation symbols respectively on the K REs;
herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the present disclosure has the following advantages over the prior art in LTE V2X:
The method in the present disclosure may configure or change resource mapping method and starting multicarrier symbol according to a time length occupied by AGC, thus reducing the impact of increasing bit error rate incurred by AGC or avoiding transmission failure.

The method in the present disclosure may judge a number of multicarrier symbols occupied by AGC according to a numerology employed in transmission, thereby adjusting a position of a starting multicarrier symbol of resource mapping, so as to realize a balance between decoding delay and link performance.

The method in the present disclosure may effectively avoid the loss of information bits in system codes in channel coding incurred by AGC, thus improving decoding performance.

### BRIEF DESCRIPTION OF THE DRAWINGS

Other features, objects and advantages of the present disclosure will become more apparent from the detailed description of non-restrictive embodiments taken in conjunction with the following drawings:
FIG. 1 illustrates a flowchart of first information and K modulation symbols according to one embodiment of the present disclosure.
FIG. 2 illustrates a schematic diagram of a network architecture according to one embodiment of the present disclosure.
FIG. 3 illustrates a schematic diagram of a radio protocol architecture of a user plane and a control plane according to one embodiment of the present disclosure.
FIG. 4 illustrates a schematic diagram of a first communication node and a second communication node according to one embodiment of the present disclosure.
FIG. 5 illustrates a flowchart of a radio signal transmission according to one embodiment of the present disclosure.
FIG. 6 illustrates a schematic diagram of K REs according to one embodiment of the present disclosure.
FIG. 7 illustrates a schematic diagram of a first time interval according to one embodiment of the present disclosure.
FIG. 8 illustrate a schematic diagram of relation(s) of K3 RE(s) and a first bit block according to one embodiment of the present disclosure.
FIG. 9 illustrates a schematic diagram of generation of a target modulation-symbol sequence according to one embodiment of the present disclosure.
FIG. 10 illustrates a schematic diagram of a relation between a first RE and a second RE according to one embodiment of the present disclosure.
FIG. 11 illustrates a schematic diagram of a relation between a first modulation-symbol group and a second modulation-symbol group according to one embodiment of the present disclosure.
FIG. 12 illustrates a schematic diagram of relations among an SCS of a subcarrier occupied by K REs, M and index of a first multicarrier symbol according to one embodiment of the present disclosure.
FIG. 13 illustrates a structure block diagram of a processing device in a first communication node according to one embodiment of the present disclosure.
FIG. 14 illustrates a structure block diagram of a processing device in a second communication node according to one embodiment of the present disclosure.

### DESCRIPTION OF THE EMBODIMENTS

The technical scheme of the present disclosure is described below in further details in conjunction with the drawings. It should be noted that the embodiments of the present disclosure and the characteristics of the embodiments may be arbitrarily combined if no conflict is caused.

### Embodiment 1

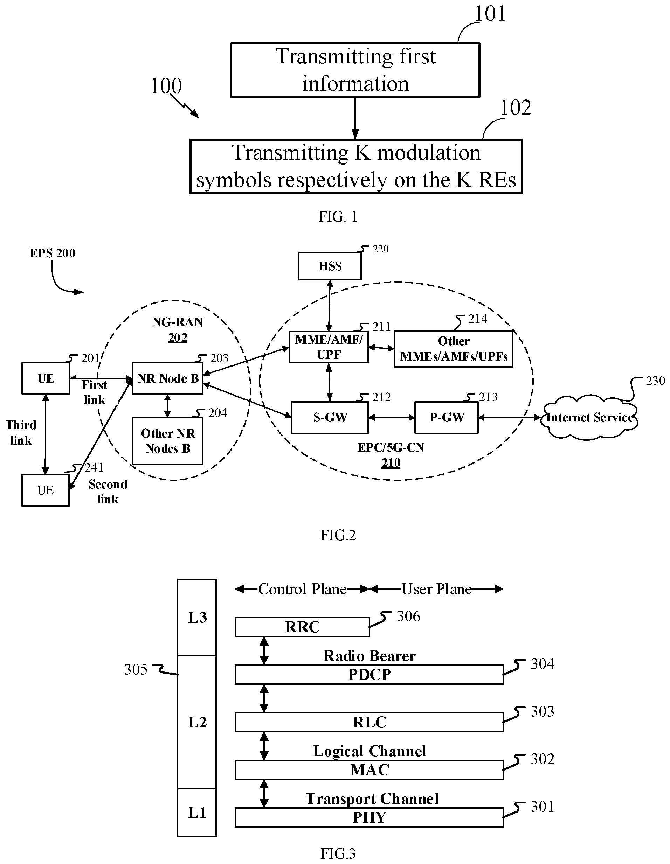

Embodiment 1 illustrates a flowchart of first information and K modulation symbols according to one embodiment of the present disclosure, as shown in FIG. 1. In FIG. 1, each box represents a step. In Embodiment 1, a first communication node in the present disclosure transmits first information, the first information is used for indicating K REs, time-domain resources occupied by the K REs comprise M multicarrier symbols, K and M being positive integers greater than 1, and the first information is transmitted via an air interface; and transmits K modulation symbols respectively on the K REs; herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the first communication node in the present disclosure is a base station(eNB or gNB).

In one embodiment, the first communication node in the present disclosure is a UE.

In one embodiment, the first communication node in the present disclosure is a V2X UE.

In one embodiment, the first communication node in the present disclosure is a V2X communication module.

In one embodiment, the first information is a piece of physical-layer information.

In one embodiment, the first information is a piece of higher-layer information.

In one embodiment, the first information is transmitted via a physical layer signaling.

In one embodiment, the first information is transmitted through a Physical Sidelink Control Channel (PSCCH).

In one embodiment, the first information is transmitted through a Physical Sidelink Shared Channel (PSSCH).

In one embodiment, the first information comprises all or part of Sidelink Control Information(SCI).

In one embodiment, the first information comprises all or partial fields of SCI.

In one embodiment, the first information comprises all or partial fields of Downlink Control Information (DCI).

In one embodiment, the first information comprises all or part of a higher-layer signaling.

In one embodiment, the first information comprises all or partial IEs in a higher-layer signaling.

In one embodiment, the first information comprises all or partial IEs in a Radio Resource Control (RRC) signaling.

In one embodiment, the first information comprises all or partial fields in an IE in a higher-layer signaling.

In one embodiment, the first information being used for indicating the K REs means that the first information is used for directly indicating the K REs.

In one embodiment, the first information being used for indicating the K REs means that the first information is used for indirectly indicating the K REs.

In one embodiment, the first information being used for indicating the K REs means that the first information is used for explicitly indicating the K REs.

In one embodiment, the first information being used for indicating the K REs means that the first information is used for implicitly indicating the K REs.

In one embodiment, the first information being used for indicating the K REs means that the first information is used for indicating time-frequency resources occupied by the K REs.

In one embodiment, the first information being used for indicating a time-domain position of the first multicarrier symbol among the M multicarrier symbols means that the first information is used for directly indicating a time-domain position of the first multicarrier symbol among the M multicarrier symbols.

In one embodiment, the first information being used for indicating a time-domain position of the first multicarrier symbol among the M multicarrier symbols means that the first information is used for indirectly indicating a time-domain position of the first multicarrier symbol among the M multicarrier symbols.

In one embodiment, the first information being used for indicating a time-domain position of the first multicarrier symbol among the M multicarrier symbols means that the first information is used for explicitly indicating a time-domain position of the first multicarrier symbol among the M multicarrier symbols.

In one embodiment, the first information being used for indicating a time-domain position of the first multicarrier symbol among the M multicarrier symbols means that the first information is used for implicitly indicating a time-domain position of the first multicarrier symbol among the M multicarrier symbols.

In one embodiment, the K REs belong to a positive integer number of Physical Resource Block(s) (PRB) in frequency domain.

In one embodiment, the K REs belong to a positive integer number of subchannel(s) in frequency domain.

In one embodiment, the K REs belong to a same subframe in time domain.

In one embodiment, the K REs belong to a same slot in time domain.

In one embodiment, the K REs belong to a same sub-slot in time domain.

In one embodiment, the K REs belong to a same mini-slot in time domain.

In one embodiment, the K REs belong to a positive integer slot(s) in time domain.

In one embodiment, the K REs occupy a positive integer number of multicarrier symbol(s)(e.g., Orthogonal Frequency Division Multiplexing(OFDM) symbol or Discrete Fourier Transform Spread Orthogonal Frequency Division Multiplexing (DFT-s-OFDM) symbol).

In one embodiment, the K REs belong to a first time-frequency resource, the first time-frequency resource occupies a positive integer number of PRB(s) in frequency domain, and the first time-frequency resource occupies a positive integer number of multicarrier symbol(s) in time domain.

In one embodiment, the K REs belong to a first time-frequency resource, the first time-frequency resource occupies a positive integer number of PRB(s) in frequency domain, the first time-frequency resource occupies a positive integer number of multicarrier symbol(s) in time domain, and the first time-frequency resource comprises an RE other than the K REs.

In one embodiment, the K REs belong to a first time-frequency resource, the first time-frequency resource occupies a positive integer number of PRB(s) in frequency domain, the first time-frequency resource occupies a positive integer number of multicarrier symbol(s) in time domain, and the first time-frequency resource only comprises the K REs.

In one embodiment, time-domain resources occupied by the K REs only comprise the M multicarrier symbols.

In one embodiment, time-domain resources occupied by the K REs comprise a multicarrier symbol other than the M multicarrier symbols.

In one embodiment, each of the K REs occupies a multicarrier symbol (comprising a Cyclic Prefix(CP)) in time domain, and a subcarrier in frequency domain.

In one embodiment, the M multicarrier symbols occupy consecutive time-domain resources.

In one embodiment, the M multicarrier symbols occupy discrete time-domain resources.

In one embodiment, the M multicarrier symbols are M consecutive multicarrier symbols in time domain.

In one embodiment, the M multicarrier symbols are M discrete multicarrier symbols in time domain.

In one embodiment, the K is greater than M.

In one embodiment, the K is positive integral multiple of M.

In one embodiment, the air interface is wireless.

In one embodiment, the air interface comprises a wireless channel.

In one embodiment, the air interface is an interface between the second communication node and the first communication node.

In one embodiment, the air interface is a Uu interface.

In one embodiment, the air interface is a Pc5 interface.

In one embodiment, the air interface is through a Sidelink.

In one embodiment, the K modulation symbols are carried by a radio signal, and the radio signal carrying the K modulation symbols is transmitted via the air interface.

In one embodiment, transmitting the K modulation symbols respectively on the K REs means that the K modulation symbols are respectively resource mapped onto the K REs.

In one embodiment, transmitting the K modulation symbols respectively on the K REs means that the K modulation symbols are carried by a second radio signal, and the second radio signal is transmitted by the K REs.

In one embodiment, transmitting the K modulation symbols respectively on the K REs means that the K modulation symbols are respectively resource mapped onto the K REs, and obtains a second radio signal sequentially through OFDM baseband signal generation, and Modulation and Upconversion, and the second radio signal is transmitted via the air interface.

In one embodiment, transmitting the K modulation symbols respectively on the K REs means that the K modulation symbols are respectively mapping to Virtual Resource Blocks, mapping from virtual to physical resource blocks, and obtains a second radio signal sequentially through OFDM baseband signal generation, and Modulation and Upconversion, and the second radio signal is transmitted via the air interface.

In one embodiment, transmitting the K modulation symbols respectively on the K REs means that the K modulation symbols are respectively resource mapped onto the K REs after through layer mapping, and obtains a second radio signal sequentially through OFDM baseband signal generation, and Modulation and Upconversion, and the second radio signal is transmitted via the air interface.

In one embodiment, transmitting the K modulation symbols respectively on the K REs means that the K modulation symbols are respectively resource mapped onto the K REs after through layer mapping and precoding, and obtains a second radio signal sequentially through OFDM baseband signal generation, and Modulation and Upconversion, and the second radio signal is transmitted via the air interface.

In one embodiment, transmitting the K modulation symbols respectively on the K REs means that the K modulation symbols are respectively mapped onto Virtual Resource Blocks after through layer mapping and precoding, mapping from virtual to physical resource block, and obtains a second radio signal sequentially through OFDM baseband signal generation, and Modulation and Upconversion, and the second radio signal is transmitted via the air interface.

In one embodiment, the first multicarrier symbol is an earliest multicarrier symbol in time domain among the M multicarrier symbols.

In one embodiment, the first multicarrier symbol is a multicarrier symbol other than an earliest multicarrier symbol in time domain among the M multicarrier symbols.

In one embodiment, the first multicarrier symbol is a multicarrier symbol other than a latest multicarrier symbol in time domain among the M multicarrier symbols.

In one embodiment, the first multicarrier symbol is a latest multicarrier symbol in time domain among the M multicarrier symbols.

In one embodiment, the first multicarrier symbol is a multicarrier symbol between a latest multicarrier symbol in time domain among the M multicarrier symbol and an earliest multicarrier symbol in time domain among the M multicarrier symbol, M is greater than 2.

In one embodiment, the K1 modulation symbols only comprise modulation symbol(s) among the K modulation symbols that is(are) mapped onto the first multicarrier symbol.

In one embodiment, any modulation symbol among the K modulation symbols that is mapped onto the first multicarrier symbol consists of the K1 modulation symbol(s).

In one embodiment, the K1 modulation symbol(s) also comprises(comprise) a modulation symbol other than modulation symbol(s) among the K modulation symbols that is(are) mapped onto the first multicarrier symbol.

In one embodiment, the first bit block is a Transport Block (TB).

In one embodiment, the first bit block is part of a TB.

In one embodiment, the first bit block is a Code Block(CB).

In one embodiment, the first bit block is transferred from a higher layer of the first communication node to a physical layer of the first communication node.

In one embodiment, an output of the first bit block through channel coding being used for generating the target modulation-symbol sequence means that the first bit block obtains modulation symbols in the target modulation-symbol sequence sequentially through CRC Insertion, Channel Coding, Rate Matching, Scrambling and Modulation.

In one embodiment, an output of the first bit block through channel coding being used for generating the target modulation-symbol sequence means that the first bit block obtains modulation symbols in the target modulation-symbol sequence sequentially through CRC Insertion, Channel Coding, Rate Matching, and Modulation.

In one embodiment, the first bit block obtains modulation symbols in the target modulation-symbol sequence sequentially through CRC Insertion, Segmentation, CRC Insertion, Channel Coding, Rate Matching, Concatenation, Scrambling, and Modulation.

In one embodiment, the first bit block obtains modulation symbols in the target modulation-symbol sequence sequentially through CRC Insertion, Segmentation, CRC Insertion, Channel Coding, Rate Matching, Concatenation, Scrambling, Modulation, Layer Mapping, and Precoding.

In one embodiment, the channel coding is Low density parity check (LDPC) coding.

In one embodiment, the channel coding is LDPC coding in 3GPP TS38.212 (V15.2.0), section 5.3.2.

In one embodiment, the channel coding is polar coding.

In one embodiment, the channel coding is polar coding in 3GPP TS38.212 (V15.2.0), section 5.3.1.

In one embodiment, the channel coding is Turbo coding.

In one embodiment, the channel coding is convolutional coding.

In one embodiment, each of the K modulation symbols is one modulation symbol in the target modulation-symbol sequence.

In one embodiment, modulation symbols in the target modulation-symbol sequence are arranged in the order of channel coding output.

In one embodiment, when K2 is greater than K1, any of the K2 modulation symbols other than the K1 modulation symbol(s) does not belong to the K modulation symbols.

In one embodiment, when K2 is greater than K1, any of the K2 modulation symbols other than the K1 modulation symbol(s) is a modulation symbol other than the K modulation symbols.

In one embodiment, when K2 is equal to K1, the K2 modulation symbol(s) is(are) the K1 modulation symbol(s).

In one embodiment, when K2 is greater than K1, the K2 modulation symbols also comprise modulation symbol(s) other than the K1 modulation symbol(s).

In one embodiment, the K2 modulation symbol(s) comprises(comprise) each of the K1 modulation symbol(s).

In one embodiment, when K2 is greater than K1, there exists one of the K2 modulation symbols being punctured during resource mapping.

In one embodiment, the K1 modulation symbol(s) comprises(comprise) a starting modulation symbol in the target modulation-symbol sequence.

In one embodiment, modulation symbols in the target modulation-symbol sequence are resource mapped from the first multicarrier symbol onto the K REs.

In one embodiment, the first multicarrier symbol is a starting multicarrier symbol when modulation symbols in the target modulation sequence are resource mapped.

In one embodiment, at least one of K or M is used for determining number of bit(s) comprised in the first bit block.

In one embodiment, a time-domain position of the first multicarrier symbol among the M multicarrier symbols refers to time-domain order of the first multicarrier symbol among the M multicarrier symbols.

In one embodiment, a time-domain position of the first multicarrier symbol among the M multicarrier symbols refers to the M multicarrier symbols being indexed in order of time, an index of the first multicarrier symbol among the M multicarrier symbols.

In one embodiment, a time-domain position of the first multicarrier symbol among the M multicarrier symbols refers to an arrangement position of the first multicarrier symbol among the M multicarrier symbols.

In one embodiment, for a given SCS of a subcarrier occupied by the K REs and a given CP length, a time-domain position of the first multicarrier symbol among the M multicarrier symbols refers to a position of the first multicarrier symbol corresponding to an earliest multicarrier symbol in time domain among the M multicarrier symbols.

In one embodiment, for a given SCS of a subcarrier occupied by the K REs and a given CP length, a time-domain position of the first multicarrier symbol among the M multicarrier symbols refers to a time length of a time interval between a start time of the first multicarrier symbol and a start time of an earliest multicarrier symbol in time domain among the M multicarrier symbols.

In one embodiment, for a given SCS of a subcarrier occupied by the K REs and a given CP length, a time-domain position of the first multicarrier symbol among the M multicarrier symbols refers to a time length of a time interval between an end time of the first multicarrier symbol and an end time of an earliest multicarrier symbol in time domain among the M multicarrier symbols.

In one embodiment, for a given SCS of a subcarrier occupied by the K REs and a given CP length, a time-domain position of the first multicarrier symbol among the M multicarrier symbols refers to the M multicarrier symbols being indexed in order of time, a difference value between an index value of the first multicarrier symbol and an earliest multicarrier symbol in time domain among the M multicarrier symbol.

In one embodiment, for a given SCS of a subcarrier occupied by the K REs and a given CP length, the M multicarrier symbols are indexed in order of time, an index value of the first multicarrier symbol is not greater than a first index value, the first index value is not greater than an index value of a latest multicarrier symbol in time domain among the M multicarrier symbols, the first index value is fixed, and a time-domain position of the first multicarrier symbol among the M multicarrier symbols refers to an index value of the first multicarrier symbol which is not greater than the first index value.

In one embodiment, for a given SCS of a subcarrier occupied by the K REs and a given CP length, the M multicarrier symbols are indexed in order of time, an index value of the first multicarrier symbol is not greater than a first index value, the first index value is not greater than an index value of a latest multicarrier symbol in time domain among the M multicarrier symbols, the first index value is unrelated to M, and a time-domain position of the first multicarrier symbol among the M multicarrier symbols refers to an index value of the first multicarrier symbol which is not greater than the first index value.

In one embodiment, for a given SCS of a subcarrier occupied by the K REs and a given CP length, a time-domain position of the first multicarrier symbol among the M multicarrier symbols refers to a time length of a time interval between a start time of the first multicarrier symbol and a start time of an earliest multicarrier symbol in time domain among the M multicarrier symbols, the time length of a time interval between a start time of the first multicarrier symbol and a start time of an earliest multicarrier symbol in time domain among the M multicarrier symbols being not greater than a first length, and the first length being unrelated to the M.

In one embodiment, for a given SCS of a subcarrier occupied by the K REs and a given CP length, a time-domain position of the first multicarrier symbol among the M multicarrier symbols refers to a time length of a time interval between an end time of the first multicarrier symbol and an end time of an earliest multicarrier symbol in time domain among the M multicarrier symbols, the time length of a time interval between an end time of the first multicarrier symbol and an end time of an earliest multicarrier symbol in time domain among the M multicarrier symbols being not greater than a first length, and the first length being unrelated to the M.

In one embodiment, an SCS of a subcarrier occupied by the K REs is equal to one of 15KHz, 30KHz , 60KHz , 120KHz , 240KHz or 480KHz.

In one embodiment, an SCS of a subcarrier occupied by the K REs is related to a Frequency Range(FR) of a carrier to which the K REs belong in frequency domain.

In one embodiment, when a carrier to which the K REs belong in frequency domain belongs to FR1(below 6GHz), and an SCS of a subcarrier occupied by the K REs is equal to one of 15KHz, 30KHz, or 60KHz; when a carrier to which the K REs belong in frequency domain belongs to FR2(that is, below 6GHz), and an SCS of a subcarrier occupied by the K REs is equal to one of 60KHz, 120KHz , 240KHz or 480KHz.

In one embodiment, the K modulation symbols are mapped onto the K REs in order of first frequency and then time.

In one embodiment, the K modulation symbols are mapped onto the K REs in order of time first and then frequency.

In one embodiment, a time-domain position of the first multicarrier symbol among the M multicarrier symbols being related to at least one of an SCS of a subcarrier occupied by the K REs or M means that a time-domain position of the first multicarrier symbol among the M multicarrier symbols is related to an SCS of a subcarrier occupied by the K REs.

In one embodiment, a time-domain position of the first multicarrier symbol among the M multicarrier symbols being related to at least one of an SCS of a subcarrier occupied by the K REs or M means that a time-domain position of the first multicarrier symbol among the M multicarrier symbols is related to M.

In one embodiment, a time-domain position of the first multicarrier symbol among the M multicarrier symbols being related to at least one of an SCS of a subcarrier occupied by the K REs or M means that a time-domain position of the first multicarrier symbol among the M multicarrier symbols is related to both an SCS of a subcarrier occupied by the K REs and M.

In one embodiment, a time-domain position of the first multicarrier symbol among the M multicarrier symbols being related to at least one of an SCS of a subcarrier occupied by the K REs or M means that at least one of an SCS of a subcarrier occupied by the K REs or M is used for determining a time-domain position of the first multicarrier symbol among the M multicarrier symbols.

In one embodiment, a time-domain position of the first multicarrier symbol among the M multicarrier symbols being related to at least one of an SCS of a subcarrier occupied by the K REs or M means that a time-domain position of the first multicarrier symbol among the M multicarrier symbols has a mapping relation with at least one of an SCS of a subcarrier occupied by the K REs or M.

In one embodiment, a time-domain position of the first multicarrier symbol among the M multicarrier symbols being related to at least one of an SCS of a subcarrier occupied by the K REs or M means that a time-domain position of the first multicarrier symbol among the M multicarrier symbols has a functional relation with at least one of an SCS of a subcarrier occupied by the K REs or M.

In one embodiment, a time-domain position of the first multicarrier symbol among the M multicarrier symbols being related to at least one of an SCS of a subcarrier occupied by the K REs or M means that a time-domain position of the first multicarrier symbol among the M multicarrier symbols has a corresponding relation with at least one of an SCS of a subcarrier occupied by the K REs or M.

In one embodiment, a time-domain position of the first multicarrier symbol among the M multicarrier symbols being related to an SCS of a subcarrier occupied by the K REs means that for given M, an FR(comprising FR1 and FR2) of a carrier to which K REs belong is used for determining a time-domain position of the first multicarrier symbol among the M multicarrier symbols, and an FR of a carrier to which the K REs belong is also used for determining an SCS of a subcarrier occupied by the K REs.

### Embodiment 2

Embodiment 2 illustrates a schematic diagram of a network architecture according to the present disclosure, as shown in FIG. 2. FIG. 2 is a diagram illustrating a network architecture 200 of 5G NR, Long-Term Evolution (LTE), and Long-Term Evolution Advanced (LTE-A) systems. The 5G NR or LTE network architecture 200 may be called an Evolved Packet System (EPS) 200 The EPS 200 may comprise one or more UEs 201, an NG-RAN 202, an Evolved Packet Core/5G-Core Network (EPC/5G-CN) 210, a Home Subscriber Server (HSS) 220 and an Internet Service 230. The EPS 200 may be interconnected with other access networks. For simple description, the entities/interfaces are not shown. As shown in FIG. 2, the EPS 200 provides packet switching services. Those skilled in the art will readily understand that various concepts presented throughout the present disclosure can be extended to networks providing circuit switching services or other cellular networks. The NG-RAN 202 comprises an NR node B (gNB) 203 and other gNBs 204. The gNB 203 provides UE 201-oriented user plane and control plane protocol terminations. The gNB 203 may be connected to other gNBs 204 via an Xn interface (for example, backhaul). The gNB 203 may be called a base station, a base transceiver station, a radio base station, a radio transceiver, a transceiver function, a Base Service Set (BSS), an Extended Service Set (ESS), a Transmitter Receiver Point (TRP) or some other applicable terms. In V2X network, the gNB 203 may be a base station, a terrestrial base station relayed via a satellites or a Road Side Unit(RSU) and etc. The gNB 203 provides an access point of the EPC/5G-CN 210 for the UE 201. Examples of the UE 201 include cellular phones, smart phones, Session Initiation Protocol (SIP) phones, laptop computers, Personal Digital Assistant (PDA), Satellite Radios, Global Positioning Systems (GPSs), multimedia devices, video devices, digital audio players (for example, MP3 players), cameras, game consoles, unmanned aerial vehicles (UAV), aircrafts, narrow-band physical network devices, machine-type communication devices, land vehicles, automobiles, communication units in vehicles, wearable devices, or any other similar functional devices. Those skilled in the art also can call the UE 201 a mobile station, a subscriber station, a mobile unit, a subscriber unit, a wireless unit, a remote unit, a mobile device, a wireless device, a radio communication device, a remote device, a mobile subscriber station, an access terminal, a mobile terminal, a wireless terminal, a remote terminal, a handset, a user proxy, a mobile client, a client, a vehicle terminal, V2X equipment or some other appropriate terms. The gNB 203 is connected to the EPC/5G-CN 210 via an S1/NG interface. The EPC/5G-CN 210 comprises a Mobility Management Entity/ Authentication Management Field/User Plane Function (MME/AMF/UPF) 211, other MMEs/AMFs/UPFs 214, a Service Gateway (S-GW) 212 and a Packet Date Network Gateway (P-GW) 213. The MME/AMF/UPF 211 is a control node for processing a signaling between the UE 201 and the EPC/5G-CN 210. Generally, the MME/AMF/UPF 211 provides bearer and connection management. All user Internet Protocol (IP) packets are transmitted through the S-GW 212, the S-GW 212 is connected to the P-GW 213. The P-GW 213 provides UE IP address allocation and other functions. The P-GW 213 is connected to the Internet Service 230. The Internet Service 230 comprises IP services corresponding to operators, specifically including Internet, Intranet, IP Multimedia Subsystem (IMS) and Packet Switching Streaming Services (PSS).

In one embodiment, the UE 201 corresponds to the first communication node in the present disclosure.

In one embodiment, the UE 201 supports Sidelink transmission.

In one embodiment, the UE 201 supports a PC5 interface.

In one embodiment, the UE 201 supports Internet of Vehicles.

In one embodiment, the UE 201 supports V2X traffic.

In one embodiment, the gNB 203 corresponds to the first communication node in the present disclosure.

In one embodiment, the UE 241 corresponds to the second communication node in the present disclosure.

In one embodiment, the UE 241 supports Sidelink transmission.

In one embodiment, the UE 241 supports a PC5 interface.

In one embodiment, the UE241 supports Internet of Vehicles.

In one embodiment, the UE241 supports V2X traffic.

In one embodiment, the UE 201 and the UE 241 are located within coverage of a same base station.

In one embodiment, the UE 201 and the UE 241 are located within coverage of different base stations.

In one embodiment, the UE 201 and the UE 241 are located out of coverage of any base station.

In one embodiment, one of the UE 201 or the UE 241 is located within coverage of a base station, and the other is located out of coverage of any base station.

### Embodiment 3

Embodiment 3 illustrates a schematic diagram of an example of a radio protocol architecture of a user plane and a control plane according to one embodiment of the present disclosure, as shown in FIG. 3. FIG. 3 is a schematic diagram illustrating an embodiment of a radio protocol architecture of a user plane and a control plane(if supported). In FIG. 3, the radio protocol architecture between a first communication node (UE or RSU in V2X) and a second communication node (another UE or RSU in V2X) is represented by three layers, which are a layer 1, a layer 2 and a layer 3, respectively. The layer 1 (L1) is the lowest layer and performs signal processing functions of various PHY layers. The L1 is called PHY 301 in the present disclosure. The layer 2 (L2) 305 is above the PHY 301, and is in charge of the link between the first communication node and the second communication node via the PHY 301. In the user plane, L2 305 comprises a Medium Access Control (MAC) sublayer 302, a Radio Link Control (RLC) sublayer 303 and a Packet Data Convergence Protocol (PDCP) sublayer 304. Although not described in FIG. 3, the first communication node and second communication node may comprise several higher layers above the L2 305, such as a network layer (e.g., IP layer) terminated at a P-GW of the network side and an application layer terminated at the other side of the connection (e.g., a peer UE, a server, etc.). The PDCP sublayer 304 provides multiplexing among variable radio bearers and logical channels. The PDCP sublayer 304 also provides a header compression for a higher-layer data packet so as to reduce a radio transmission overhead. The PDCP sublayer 304 provides security by encrypting a packet. The RLC sublayer 303 provides segmentation and reassembling of a higher-layer packet, retransmission of a lost packet, and reordering of a data packet so as to compensate the disordered receiving caused by HARQ. The MAC sublayer 302 provides multiplexing between a logical channel and a transport channel. The MAC sublayer 302 is also responsible for allocating various radio resources (i.e., resources block) The MAC sublayer 302 is also in charge of HARQ operation (if supported). In the control plane, the radio protocol architecture of the first communication node and the second communication node is almost the same as the radio protocol architecture on the PHY 301 and the L2 305, but there is no header compression for the control plane. The control plane also comprises a Radio Resource Control (RRC) sublayer 306 in the layer 3 (L3). The RRC sublayer 306 is responsible for acquiring radio resources (i.e., radio bearer) and configuring the lower layer using an RRC signaling.

In one embodiment, the radio protocol architecture in FIG. 3 is applicable to the first communication node in the present disclosure.

In one embodiment, the radio protocol architecture in FIG. 3 is applicable to the second communication node in the present disclosure.

In one embodiment, the first information in the present disclosure is generated by the RRC 306.

In one embodiment, the first information in the present disclosure is generated by the MAC 302.

In one embodiment, the first information in the present disclosure is generated by the PHY 301.

In one embodiment, the first bit block in the present disclosure is generated by the RRC 306.

In one embodiment, the first bit block in the present disclosure is generated by the MAC 302.

In one embodiment, the first bit block in the present disclosure is generated by the PHY 301.

In one embodiment, the K modulation symbols in the present disclosure are generated by the PHY 301.

In one embodiment, the first radio signal in the present disclosure is generated by the RRC 306.

In one embodiment, the first radio signal in the present disclosure is generated by the MAC 302.

In one embodiment, the first radio signal in the present disclosure is generated by the PHY 301.

### Embodiment 4

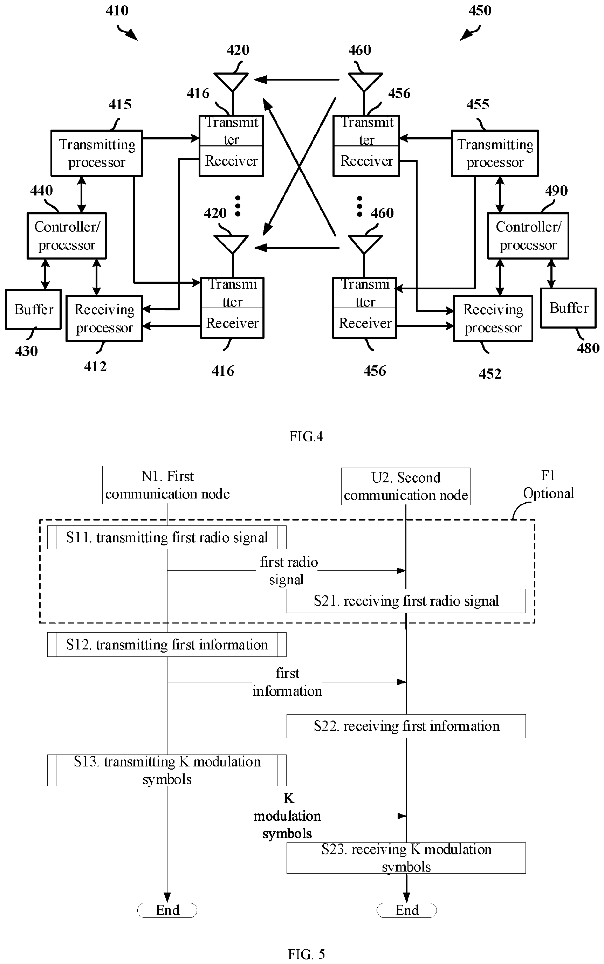

Embodiment 4 illustrates a schematic diagram of a first communication node and a second communication node in the present disclosure, as shown in FIG. 4.

The first communication node (450) comprises a controller/processor 490, a memory 480, a receiving processor 452, a transmitter/receiver 456, a transmitting processor 455 and a data source 467, wherein the transmitter/receiver 456 comprises an antenna 460. The data source 467 provides a higher-layer packet to the controller/processor 490, the controller/processor 490 provides header compression and decompression, encryption and decryption, packet segmentation and reordering and multiplexing and demultiplexing between a logical channel and a transport channel so as to implement the L2 layer protocols used for the user plane and the control plane. The higher layer packet may comprise data or control information, such as DL-SCH, UL-SCH or SL-SCH. The transmitting processor 455 performs various signal transmitting processing functions used for the L1 layer (that is, PHY), including coding, interleaving, scrambling, modulation, power control/allocation, precoding and generation of physical layer control signaling. The receiving processor 452 performs various signal receiving processing functions used for the L1 layer (that is, PHY), including decoding, deinterleaving, descrambling, demodulation, de-precoding and extraction of physical layer control signaling. The transmitter 456 is configured to convert a baseband signal provided by the transmitting processor 455 into a radio frequency (RF) signal to be transmitted via the antenna 460. The receiver 456 converts the RF signal received via the antenna 460 into a baseband signal and provides the baseband signal to the receiving processor 452. The composition in the second communication node device (410) is the same as that in the first communication node device 450.

In Sidelink, a higher layer packet (for example, first information, a first bit block and information carried in a first radio signal in the present disclosure) is provided to the controller/processor 490. The controller/processor 490 implements functions of L2 layer. The controller/processor 490 provides header compression, encryption, packet segmentation and reordering, multiplexing between a logical channel and a transport channel, and radio resources allocation based on various priorities. The controller/processor 490 is also in charge of HARQ operation(if supported), retransmission of a lost packet, and a signaling to the second communication node 410, for instance, the first information in the present disclosure is generated in the controller/processor 490. The transmitting processor 455 performs signal processing functions of the L1 layer (that is, PHY), including coding, interleaving, scrambling, modulation, power control/allocation, precoding and physical layer control signaling generation. Generation of physical layer signals carrying the first information, K modulation symbols and a first radio signal of the present disclosure is performed in the transmitting processor 455. Modulated signals are divided into parallel streams and each stream is mapped onto corresponding multicarrier subcarriers and/or multicarrier symbols, which are then mapped from the transmitting processor 455 onto the antenna 460 via the transmitter 456 to be transmitted in the form of RF signals. At the receiving side, each receiver 416 receives an RF signal via a corresponding antenna 420, each receiver 416 recovers baseband information modulated to the RF carrier and provides the baseband information to the receiving processor 412. The receiving processor 412 provides various signal receiving functions for the L1 layer. The signal receiving processing functions include reception of physical layer signals carrying the first information, K modulation symbols and a first radio signal of the present disclosure, demodulation of multicarrier symbols in multicarrier symbol streams based on each modulation scheme (e.g., BPSK, QPSK), and then descrambling, decoding and de-interleaving of the demodulated symbols so as to recover data or control signals transmitted by the first communication node 450 on a physical channel, and the data or control signals are later provided to the controller/processor 440. The controller/processor 440 implements the functionality of the L2 layer, the controller/processor 440 interprets the first information, the first bit block and information carried by the first radio signal of the present disclosure. The controller/processor can be connected to a memory 430 that stores program code and data. The memory 430 may be called a computer readable medium.

In one embodiment, the first communication node 450 comprises at least one processor and at least one memory. The at least one memory comprises computer program codes; the at least one memory and the computer program codes are configured to be used in collaboration with the at least one processor, the first communication node 450 at least transmits first information, the first information is used for indicating K REs, time-domain resources occupied by the K REs comprise M multicarrier symbols, K and M being positive integers greater than 1, the first information is transmitted via an air interface; and transmits K modulation symbols respectively on the K REs; herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the first communication node 450 comprises a memory that stores a computer readable instruction program. The computer readable instruction program generates an action when executed by at least one processor. The action includes: transmitting first information, the first information being used for indicating K REs, time-domain resources occupied by the K REs comprising M multicarrier symbols, K and M being positive integers greater than 1, the first information being transmitted via an air interface; and transmitting K modulation symbols respectively on the K REs; herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the second communication node 410 comprises at least one processor and at least one memory. The at least one memory comprises computer program codes; the at least one memory and the computer program codes are configured to be used in collaboration with the at least one processor. The second communication node 410 at least: receives first information, the first information is used for indicating K REs, time-domain resources occupied by the K REs comprise M multicarrier symbols, K and M being positive integers greater than 1, and the first information is transmitted via an air interface; and receives K modulation symbols respectively on the K REs; herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the second communication node 410 comprises a memory that stores a computer readable instruction program. The computer readable instruction program generates an action when executed by at least one processor. The action includes: receiving first information, the first information being used for indicating K REs, time-domain resources occupied by the K REs comprising M multicarrier symbols, K and M being positive integers greater than 1, the first information being transmitted via an air interface; and receiving K modulation symbols respectively on the K REs; herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the transmitter 456 (including the antenna 460), the transmitting processor 455 and the controller/processor 490 are for transmitting the first information in the present disclosure.

In one embodiment, the controller/processor 490 is used for generating the first bit block in the present disclosure.

In one embodiment, the transmitter 456 (including the antenna 460), and the transmitting processor 455 are used for transmitting the K modulation symbols in the present disclosure.

In one embodiment, the transmitter 456 (including the antenna 460), the transmitting processor 455 and the controller/processor 490 are used for transmitting the first radio signal in the present disclosure.

In one embodiment, the receiver 416 (including the antenna 420), the receiving processor 412 and the controller/processor 440 are used for receiving the first information in the present disclosure.

In one embodiment, the controller/processor 440 is used for reading the first bit block in the present disclosure.

In one embodiment, the receiver 416 (including the antenna 420) and the receiving processor 412 are used for receiving the K modulation symbols in the present disclosure.

In one embodiment, the receiver 416 (including the antenna 420), the receiving processor 412 and the controller/processor 440 are used for receiving the first radio signal in the present disclosure.

### Embodiment 5

Embodiment 5 illustrates a flowchart of a radio signal transmission according to one embodiment in the present disclosure, as shown in FIG. 5. In FIG. 5, a first communication node N1 and a second communication node U2 are in communication with each other, wherein steps in dotted box are optional.

**The first communication node N1** transmits a first radio signal in step S11, transmits first information in step S12, and transmits K modulation symbols respectively on K REs in step S13.

**The second communication node U2** receives a first radio signal in step S21, receives first information in step S22, and receives K modulation symbols respectively on K REs in step S23.

In Embodiment 5, the first information is used for indicating K REs, time-domain resources occupied by the K REs comprise M multicarrier symbols, K and M being positive integers greater than 1, and the first information is transmitted via an air interface; a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols; an end time for transmitting the first radio signal is not later than a start time for transmitting the K modulation symbols, and a time interval between an end time for transmitting the first radio signal and a start time for transmitting the K modulation symbols is a first time interval; for a given SCS of a subcarrier occupied by the K REs and given M, a time-domain position of the first multicarrier symbol among the M multicarrier symbols is related to a time length of the first time interval.

In one embodiment, when the first multicarrier symbol is a multicarrier symbol other than an earliest multicarrier symbol in time domain among the M multicarrier symbols, any multicarrier symbol occupied by K3 RE(s) among the K REs in time domain is not earlier than the first multicarrier symbol, K3 being a positive integer less than K; at least one of K3 or a number of multicarrier symbol(s) occupied by the K3 RE(s) is used for determining a number of bit(s) comprised in the first bit block.

In one embodiment, for given the K REs and given M, a number of modulation symbols comprised in the target modulation-symbol sequence is related to a time-domain position of the first multicarrier symbol among the M multicarrier symbols.

In one embodiment, when the first multicarrier symbol is a multicarrier symbol other than an earliest multicarrier symbol in time domain among the M multicarrier symbols, there exist a first RE and a second RE among the K REs, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a modulation symbol occupying the first RE among the K modulation symbols is the same as a modulation symbol occupying the second RE among the K modulation symbols.

In one embodiment, when the first multicarrier symbol is a multicarrier symbol other than an earliest multicarrier symbol in time domain among the M multicarrier symbols, any multicarrier symbol occupied by K4 RE(s) among the K REs in time domain is earlier than the first multicarrier symbol, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

In one embodiment, the M multicarrier symbols are indexed in order of time, an index value of the first multicarrier symbol among the M multicarrier symbols is one of X1 candidate index value(s);
for given M, an SCS of a subcarrier occupied by the K REs is one of X2 candidate SCS(s), for each of the X2 candidate SCS(s), there exists one of the X1 candidate index value(s) that corresponds to the candidate SCS;
or for a given SCS of a subcarrier occupied by the K REs, M is one of X3 candidate positive integer(s), for each of the X3 candidate positive integer(s), there exists one of the X1 candidate index value(s) that corresponds to the candidate positive integer.

In one embodiment, target receivers of the first radio signal and the K modulation symbols are the same.

In one embodiment, the first communication node assumes that receivers of the first radio signal and the K modulation symbols are the same.

In one embodiment, the first communication node may assume that receivers of the first radio signal and the K modulation symbols are the same.

In one embodiment, the first radio signal and the K modulation symbols are broadcast.

In one embodiment, the first radio signal and the K modulation symbols can be received by a same receiver.

### Embodiment 6

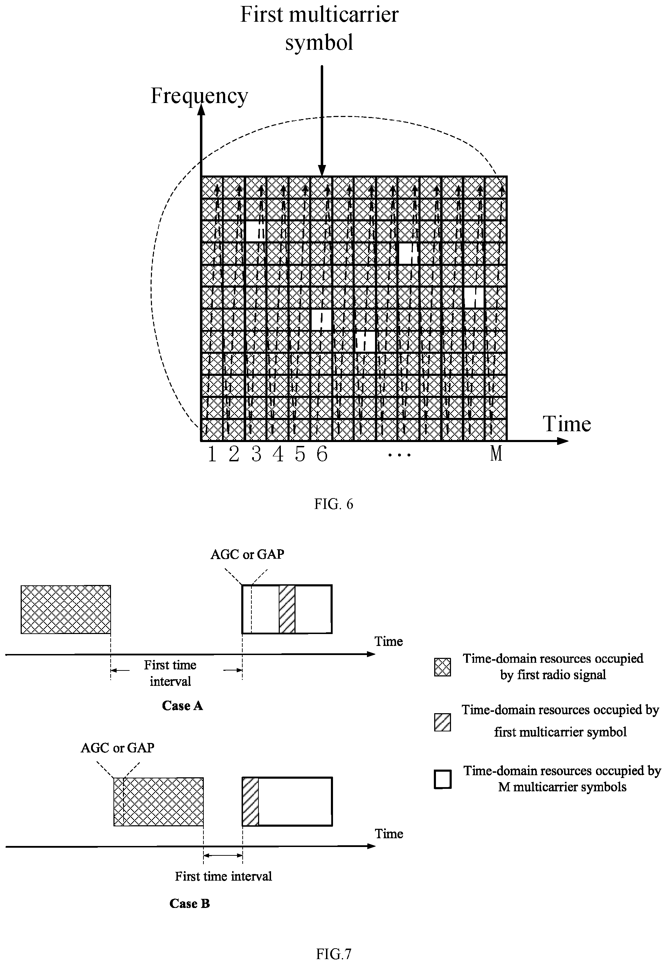

Embodiment 6 illustrates a schematic diagram of K REs according to one embodiment of the present disclosure, as shown in FIG. 6. In FIG.6, the horizontal axis represents time, the vertical axis represents frequency, each cross-line-filled square represents one of the K REs in the present disclosure, each unfilled square represents a punctured or dropped RE other than the K REs, and the dotted line with an arrow represents mapping order of the K modulation symbols when performing resource mapping.

In Embodiment 6, time-domain resources occupied by the K REs comprise M multicarrier symbols, K and M being positive integers, and K modulation symbols are respectively transmitted on the K REs; a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1.

In one embodiment, the K REs belong to a positive integer number of PRB(s) in frequency domain.

In one embodiment, the K REs belong to a positive integer number of subchannel(s) in frequency domain.

In one embodiment, the K REs belong to a same subframe in time domain.

In one embodiment, the K REs belong to a same slot in time domain.

In one embodiment, the K REs belong to a same sub-slot in time domain.

In one embodiment, the K REs belong to a same mini-slot in time domain.

In one embodiment, the K REs belong to a positive integer slot(s) in time domain.

In one embodiment, the K REs occupy a positive integer number of multicarrier symbol(s)(OFDM symbol or DFT-s-OFDM symbol).

In one embodiment, the K REs belong to a first time-frequency resource, the first time-frequency resource occupies a positive integer number of PRB(s) in frequency domain, the first time-frequency resource occupies a positive integer number of multicarrier symbol(s) in time domain.

In one embodiment, the K REs belong to a first time-frequency resource, the first time-frequency resource occupies a positive integer number of PRB(s) in frequency domain, the first time-frequency resource occupies a positive integer number of multicarrier symbol(s) in time domain, and the first time-frequency resource comprises an RE other than the K REs.

In one embodiment, the K REs belong to a first time-frequency resource, the first time-frequency resource occupies a positive integer number of PRB(s) in frequency domain, the first time-frequency resource occupies a positive integer number of multicarrier symbol(s) in time domain, and the first time-frequency resource only comprises the K REs.

In one embodiment, time-domain resources occupied by the K REs only comprise the M multicarrier symbols.

In one embodiment, time-domain resources occupied by the K REs comprise a multicarrier symbol other than the M multicarrier symbols.

In one embodiment, each of the K REs occupies a multicarrier symbol (comprising a CP) in time domain, and a subcarrier in frequency domain.

In one embodiment, the M multicarrier symbols occupy consecutive time-domain resources.

In one embodiment, the M multicarrier symbols occupy discrete time-domain resources.

In one embodiment, the M multicarrier symbols are M consecutive multicarrier symbols in time domain.

In one embodiment, the M multicarrier symbols are M discrete multicarrier symbols in time domain.

In one embodiment, the K is greater than M.

In one embodiment, the K is positive integral multiple of M.

In one embodiment, the K modulation symbols are mapped onto the K REs in the order of frequency first and then time.

In one embodiment, the K modulation symbols are mapped onto the K REs in the order of time first and then frequency.

In one embodiment, when K2 is greater than K1, any of the K2 modulation symbols other than the K1 modulation symbol(s) does not belong to the K modulation symbols.

In one embodiment, when K2 is greater than K1, any of the K2 modulation symbols other than the K1 modulation symbol(s) is a modulation symbol other than the K modulation symbols.

In one embodiment, when K2 is equal to K1, the K2 modulation symbol(s) is(are) the K1 modulation symbol(s).

In one embodiment, when K2 is greater than K1, the K2 modulation symbols also comprise a modulation symbol other than the K1 modulation symbol(s).

In one embodiment, the K2 modulation symbol(s) comprises(comprise) each of the K1 modulation symbol(s).

In one embodiment, when K2 is greater than K1, there exists one of the K2 modulation symbols being punctured during resource mapping.

In one embodiment, when K2 is greater than K1, there exists one of the K2 modulation symbols being dropped during resource mapping.

### Embodiment 7

Embodiment 7 illustrates a schematic diagram of a first time interval according to one embodiment of the present disclosure, as shown in FIG. 7. In FIG.7, the horizontal axis represents time, the cross-line-filled rectangle represents time-domain resources occupied by the first radio signal, the slash-filled rectangle represents time-domain resources occupied by a first multicarrier symbol, a thick line-framed rectangle without filling represents time-domain resources occupied by M multicarrier symbols, a time length of a first time interval in case A is longer than a time length of a first time interval in case B, and in case A and B, time-domain resources of the receiver for AGC and for GAP may be different.

In Embodiment 7, an end time for transmitting the first radio signal in the present disclosure is not later than a start time for transmitting the K modulation symbols in the present disclosure, and a time interval between an end time for transmitting the first radio signal and a start time for transmitting the K modulation symbols is a first time interval; for a given SCS of a subcarrier occupied by the K REs in the present disclosure and given M in the present disclosure, a time-domain position of the first multicarrier symbol among the M multicarrier symbols in the present disclosure is related to a time length of the first time interval.

In one embodiment, the first radio signal is generated after a TB is sequentially subjected to CRC Insertion, Channel Coding, Rate Matching, Scrambling, Modulation, Layer Mapping, Precoding, Mapping to Resource Element, OFDM Baseband Signal Generation, and Modulation and Upconversion.

In one embodiment, the first radio signal is generated after a TB is sequentially subjected to CRC Insertion, Channel Coding, Rate Matching, Scrambling, Modulation, Layer Mapping, Precoding, Mapping to Virtual Resource Blocks, Mapping from Virtual to Physical Resource Blocks, OFDM Baseband Signal Generation, and Modulation and Upconversion.

In one embodiment, the first radio signal is generated after a TB is sequentially subjected to CRC Insertion, Segmentation, coding block-level CRC Insertion, Channel Coding, Rate Matching, Concatenation, Scrambling, Modulation, Layer Mapping, Precoding, Mapping to Resource Element, OFDM Baseband Signal Generation, and Modulation and Upconversion.

In one embodiment, the first radio signal is generated after a TB is sequentially subjected to CRC Insertion, Segmentation, coding block-level CRC Insertion, Channel Coding, Rate Matching, Concatenation, Scrambling, Modulation, Layer Mapping, Precoding, Mapping to Virtual Resource Blocks, Mapping from Virtual to Physical Resource Blocks, OFDM Baseband Signal Generation, and Modulation and Upconversion.

In one embodiment, the first radio signal is generated after a TB is sequentially subjected to CRC Insertion, Channel Coding, Rate Matching, Scrambling, Modulation, Layer Mapping, Transform Precoding, Precoding, Mapping to Resource Element, OFDM Baseband Signal Generation, and Modulation and Upconversion.

In one embodiment, the first radio signal is generated after a TB is sequentially subjected to CRC Insertion, Channel Coding, Rate Matching, Scrambling, Modulation, Layer Mapping, Transform Precoding, Precoding, Mapping to Virtual Resource Blocks, Mapping from Virtual to Physical Resource Blocks, OFDM Baseband Signal Generation, and Modulation and Upconversion.

In one embodiment, the first radio signal is generated after a TB is sequentially subjected to CRC Insertion, Segmentation, coding block-level CRC Insertion, Channel Coding, Rate Matching, Concatenation, Scrambling, Modulation, Layer Mapping, Transform Precoding, Precoding, Mapping to Resource Element, OFDM Baseband Signal Generation, and Modulation and Upconversion.

In one embodiment, the first radio signal is generated after a TB is sequentially subjected to CRC Insertion, Segmentation, coding block-level CRC Insertion, Channel Coding, Rate Matching, Concatenation, Scrambling, Modulation, Layer Mapping, Transform Precoding, Precoding, Mapping to Virtual Resource Blocks, Mapping from Virtual to Physical Resource Blocks, OFDM Baseband Signal Generation, and Modulation and Upconversion.

In one embodiment, the first radio signal is generated after a piece of SCI is sequentially subjected to CRC Insertion, Channel Coding, Rate Matching, Scrambling, Modulation, Mapping to Physical Resources, OFDM Baseband Signal Generation, and Modulation and Upconversion.

In one embodiment, the first radio signal is generated after a piece of SCI is sequentially subjected to CRC Insertion, Channel Coding, Rate Matching, Scrambling, Modulation, Transform Precoding, Mapping to Physical Resources, OFDM Baseband Signal Generation, and Modulation and Upconversion.

In one embodiment, a start time for transmitting the K modulation symbols refers to a start time of time-domain resources occupied by the K REs.

In one embodiment, a start time for transmitting the K modulation symbols refers to a start time for transmitting a radio signal that carries the K modulation symbols.

In one embodiment, an end time for transmitting the first radio signal is a start time for transmitting the K modulation symbols.

In one embodiment, an end time for transmitting the first radio signal is earlier than a start time for transmitting the K modulation symbols.

In one embodiment, for a given SCS of a subcarrier occupied by the K REs and given M, a time-domain position of the first multicarrier symbol among the M multicarrier symbols being related to a time length of the first time interval means that a time-domain position of the first multicarrier symbol among the M multicarrier symbols has a corresponding relation with a time length of the first time interval.

In one embodiment, for a given SCS of a subcarrier occupied by the K REs and given M, a time-domain position of the first multicarrier symbol among the M multicarrier symbols being related to a time length of the first time interval means that a time-domain position of the first multicarrier symbol among the M multicarrier symbols has a mapping relation with a time length of the first time interval.

In one embodiment, for a given SCS of a subcarrier occupied by the K REs and given M, a time-domain position of the first multicarrier symbol among the M multicarrier symbols being related to a time length of the first time interval means that a time-domain position of the first multicarrier symbol among the M multicarrier symbols has a functional relation with a time length of the first time interval.

In one embodiment, for a given SCS of a subcarrier occupied by the K REs and given M, a time-domain position of the first multicarrier symbol among the M multicarrier symbols being related to a time length of the first time interval means that a time length of the first time interval is used for determining a time-domain position of the first multicarrier symbol among the M multicarrier symbols.

In one embodiment, for a given SCS of a subcarrier occupied by the K REs and given M, a time-domain position of the first multicarrier symbol among the M multicarrier symbols being related to a time length of the first time interval means that a time length of the first time interval belongs to one of Q candidate length interval(s), the Q candidate length interval(s) corresponds(respectively correspond) to Q candidate time-domain position(s), a time-domain position of the first multicarrier symbol among the M multicarrier symbols is one of the Q candidate time-domain position(s), and a time length of the first time interval corresponds to a time-domain position of the first multicarrier symbol among the M multicarrier symbols.

### Embodiment 8

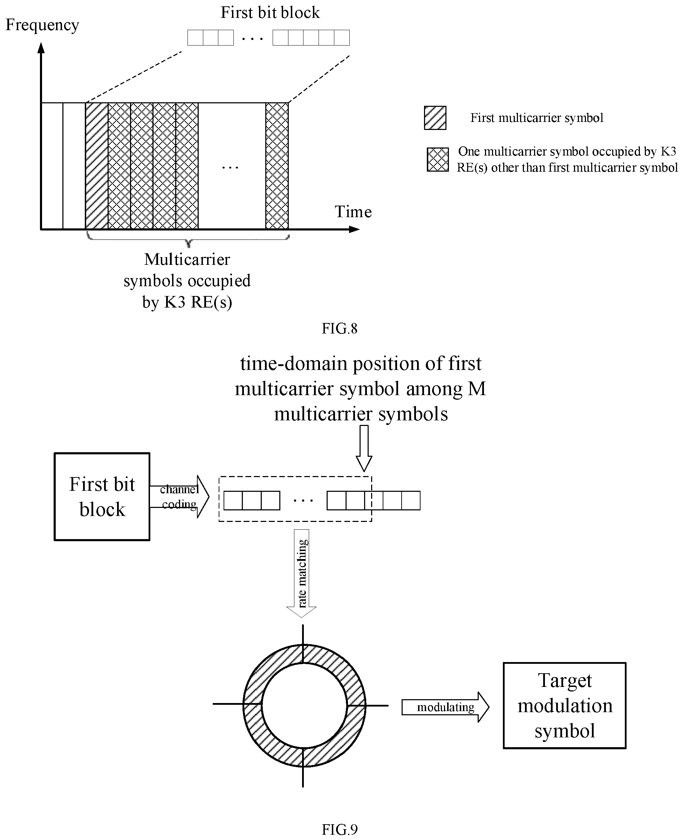

Embodiment 8 illustrates a schematic diagram of relation(s) of K3 RE(s) and a first bit block according to one embodiment of the present disclosure, as shown in FIG.8. In FIG.8, the horizontal axis represents time, the vertical axis represents frequency, a slash-filled rectangle represents a first multicarrier symbol, and a cross-line-filled rectangle represents a multicarrier symbol occupied by K3 RE(s) other than a first multicarrier symbol.

In Embodiment 8, when the first multicarrier symbol in the present disclosure is a multicarrier symbol other than an earliest multicarrier symbol in time domain among the M multicarrier symbols in the present disclosure, any multicarrier symbol occupied by K3 RE(s) among the K REs in time domain in the present disclosure is not earlier than the first multicarrier symbol, K3 being a positive integer less than K; at least one of K3 or a number of multicarrier symbol(s) occupied by the K3 RE(s) is used for determining a number of bit(s) comprised in the first bit block in the present disclosure.

In one embodiment, the first bit block is a TB, and a bit number comprised the first bit block is a Transport Block Size(TBS) of the first bit block.

In one embodiment, a multicarrier symbol occupied by each of the K3 RE(s) in time domain is not earlier than the first multicarrier symbol.

In one embodiment, at least one of K3 or a number of multicarrier symbol(s) occupied by the K3 RE(s) being used for determining a bit number comprised in the first bit block means that K3 is used for determining a bit number comprised in the first bit block.

In one embodiment, at least one of K3 or a number of multicarrier symbol(s) occupied by the K3 RE(s) being used for determining a bit number comprised in the first bit block means that a number of multicarrier symbol(s) occupied by the K3 RE(s) is(are) used for determining a bit number comprised in the first bit block.

In one embodiment, at least one of K3 or a number of multicarrier symbol(s) occupied by the K3 RE(s) being used for determining a bit number comprised in the first bit block means that K3 and a number of multicarrier symbol(s) occupied by the K3 RE(s) are both used for determining a bit number comprised in the first bit block.

In one embodiment, at least one of K3 or a number of multicarrier symbol(s) occupied by the K3 RE(s) being used for determining a bit number comprised in the first bit block means that at least one of K3 or a number of multicarrier symbol(s) occupied by the K3 RE(s) is used by the first communication node for determining a bit number comprised in the first bit block.

In one embodiment, at least one of K3 or a number of multicarrier symbol(s) occupied by the K3 RE(s) being used for determining a bit number comprised in the first bit block means that at least one of K3 or a number of multicarrier symbol(s) occupied by the K3 RE(s) is used by the second communication node in the present disclosure for determining a bit number comprised in the first bit block.

In one embodiment, at least one of K3 or a number of multicarrier symbol(s) occupied by the K3 RE(s) being used for determining a bit number comprised in the first bit block means that at least one of K3 or a number of multicarrier symbol(s) occupied by the K3 RE(s) is used for determining a bit number comprised in the first bit block based on a mapping relation.

In one embodiment, at least one of K3 or a number of multicarrier symbol(s) occupied by the K3 RE(s) being used for determining a bit number comprised in the first bit block means that at least one of K3 or a number of multicarrier symbol(s) occupied by the K3 RE(s) is used for determining a bit number comprised in the first bit block based on a functional relation.

In one embodiment, K3 is used for determining a number of bit(s) comprised in the first bit block by method in 3GPP 38.214 (V15.2.0), section 6.1.4.2.

In one embodiment, K3 is taken as N_{RE} in 3GPP 38.214 (V15.2.0), section 6.1.4.2 and is used for determining a bit number comprised in the first bit block by method in 3GPP 38.214 (V15.2.0), section 6.1.4.2.

In one embodiment, K is taken as in 3GPP 38.214 (V15.2.0), section 6.1.4.2, and is used for obtaining a first bit number by method in 3GPP 38.214 (V15.2.0), section 6.1.4.2, then scaling is performed on the first bit number according to a ratio of K3 to K to determine a bit number comprised in the first bit block.

In one embodiment, based on method in 3GPP 38.214 (V15.2.0), section 6.1.4.2, a number of PRB(s) occupied by the K REs is taken as N_{PRB} to obtain a first bit number, and scaling is performed on the first bit number according to a ratio of a number of multicarrier symbol(s) occupied by the K3 RE(s) to the M to determine a bit number comprised in the first bit block.

### Embodiment 9

Embodiment 9 illustrates a schematic diagram of generation of a target modulation-symbol sequence according to one embodiment of the present disclosure, as shown in FIG.9. In FIG.9, a slash-filled annular region represents a bit block of a target modulation symbol sequence is generated through modulation.

In Embodiment 9, for given the K REs in the present disclosure and given M in the present disclosure, a number of modulation symbols comprised in the target modulation-symbol sequence in the present disclosure is related to a time-domain position of the first multicarrier symbol in the present disclosure among the M multicarrier symbols in the present disclosure.

In one embodiment, for given modulation method, a number of modulation symbols comprised in the target modulation-symbol sequence is proportional to a maximum bit number that can be supported by circular buffer of the first bit block in channel coding.

In one embodiment, for given modulation method, a number of modulation symbols comprised in the target modulation-symbol sequence is proportional to a maximum bit number that can be supported by limited buffer of the first bit block in channel coding.

In one embodiment, for given the K REs and given M, a number of modulation symbols comprised in the target modulation-symbol sequence being related to a time-domain position of the first multicarrier symbol among the M multicarrier symbols means that a time-domain position of the first multicarrier symbol among the M multicarrier symbols is used for determining a length of circular buffer the first bit block through channel coding, and a number of modulation symbols comprised in the target modulation-symbol sequence is related to a length of circular buffer.

In one embodiment, for given the K REs and given M, a number of modulation symbols comprised in the target modulation-symbol sequence being related to a time-domain position of the first multicarrier symbol among the M multicarrier symbols means that a time-domain position of the first multicarrier symbol among the M multicarrier symbols is used for determining a target RE number in rate matching, and the target RE number is used for determining a length of circular buffer the first bit block through channel coding, and a number of modulation symbols comprised in the target modulation-symbol sequence is related to a length of circular buffer.

In one embodiment, for given the K REs and given M, a number of modulation symbols comprised in the target modulation-symbol sequence being related to a time-domain position of the first multicarrier symbol among the M multicarrier symbols means that a time-domain position of the first multicarrier symbol among the M multicarrier symbols is used for determining a number of REs not earlier than the first multicarrier symbol occupied by the K REs in time domain, a number of REs not earlier than the first multicarrier symbol occupied by the K REs in time domain is a target RE number of the first bit block through rate matching in channel coding, the target RE number is used for determining a length of circular buffer the first bit block through channel coding, and a number of modulation symbols comprised in the target modulation-symbol sequence is related to a length of circular buffer.

In one embodiment, for given the K REs and given M, a number of modulation symbols comprised in the target modulation-symbol sequence being related to a time-domain position of the first multicarrier symbol among the M multicarrier symbols means that a time-domain position of the first multicarrier symbol among the M multicarrier symbols is used for determining a number of modulation symbols comprised in the target modulation-symbol sequence.

In one embodiment, for given the K REs and given M, a number of modulation symbols comprised in the target modulation-symbol sequence being related to a time-domain position of the first multicarrier symbol among the M multicarrier symbols means that the M multicarrier symbols are indexed according to an increasing chronological order, a time-domain position of the first multicarrier symbol among the M multicarrier symbols refers to an index value of the first multicarrier symbol among the M multicarrier symbols, and a number of modulation symbols comprised in the target modulation-symbol sequence is in linear negative correlation with an index value of the first multicarrier symbol among the M multicarrier symbols.

In one embodiment, for given the K REs and given M, a number of modulation symbols comprised in the target modulation-symbol sequence being related to a time-domain position of the first multicarrier symbol among the M multicarrier symbols means that the M multicarrier symbols are indexed according to an increasing chronological order, a time-domain position of the first multicarrier symbol among the M multicarrier symbols refers to an index value of the first multicarrier symbol among the M multicarrier symbols, and a number of modulation symbols comprised in the target modulation-symbol sequence is in inverse proportional correlation with an index value of the first multicarrier symbol among the M multicarrier symbols.

### Embodiment 10

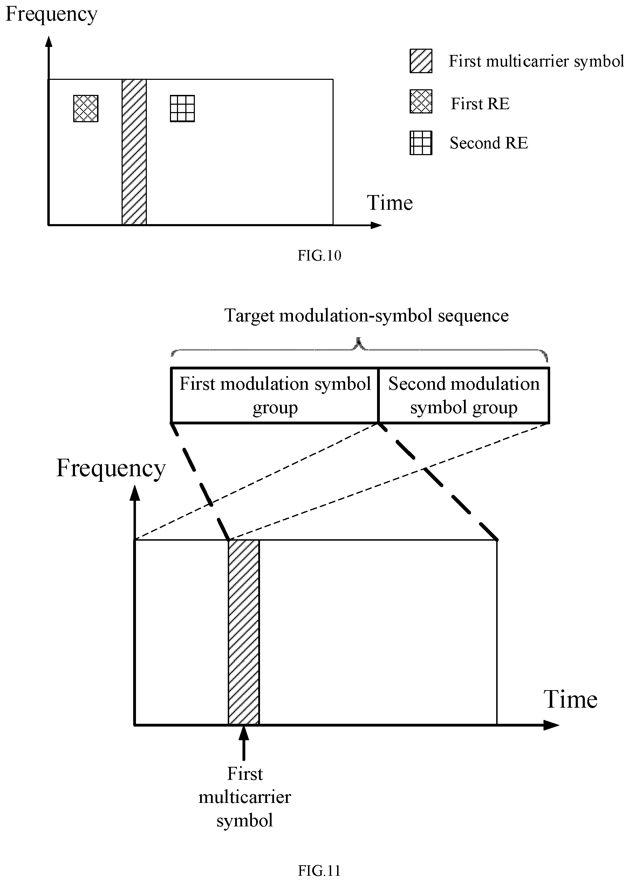

Embodiment 10 illustrates a schematic diagram of a relation between a first RE and a second RE according to one embodiment of the present disclosure, as shown in FIG.10. In FIG. 10, the horizontal axis represents time, the vertical axis represents frequency, the slash-filled rectangle represents a first multicarrier symbol, the cross-line-filled rectangle represents a first RE, and reticle-filled rectangle represents a second RE.

In embodiment 10, when the first multicarrier symbol in the present disclosure is a multicarrier symbol other than an earliest multicarrier symbol in time domain among the M multicarrier symbols in the present disclosure. There exist a first RE and a second RE among the K REs in the present disclosure, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a modulation symbol occupying the first RE among the K modulation symbols is the same as a modulation symbol occupying the second RE among the K modulation symbols.

In one embodiment, SCSs of any two REs among the K REs are the same.

In one embodiment, the first RE and the second RE occupy a same subcarrier in frequency domain.

In one embodiment, the first RE and the second RE occupy same frequency-domain resources in frequency domain.

In one embodiment, whether a modulation symbol occupying the first RE among the K modulation symbols is the same as a modulation symbol occupying the second RE among the K modulation symbols is unrelated to content of modulation symbols in the target modulation-symbol sequence.

In one embodiment, whether a modulation symbol occupying the first RE among the K modulation symbols is the same as a modulation symbol occupying the second RE among the K modulation symbols is unrelated to bit(s) in the first bit block.

In one embodiment, a modulation symbol among the K modulation symbols transmitted on a multicarrier symbol occupied by the first RE in time domain is a repetition of a modulation symbol among the K modulation symbols transmitted on a multicarrier symbol occupied by the second RE in time domain.

In one embodiment, a modulation symbol among the K modulation symbols transmitted on a multicarrier symbol occupied by the first RE in time domain is correspondingly the same as a modulation symbol among the K modulation symbols transmitted on a multicarrier symbol occupied by the second RE in time domain according to an occupied subcarrier.

In one embodiment, a modulation symbols among the K modulation symbols transmitted on a multicarrier symbol occupied by the first RE in time domain is used for generating a first subsignal, and a modulation symbol among the K modulation symbols transmitted on a multicarrier symbol occupied by the second RE in time domain is used for generating a second subsignal, and the second subsignal is a repetition of the first subsignal on two multicarrier symbols.

### Embodiment 11

Embodiment 11 illustrates a schematic diagram of a relation between a first modulation-symbol group and a second modulation-symbol group according to one embodiment of the present disclosure, as shown in FIG.11. In FIG. 11, the horizontal axis represents time, the vertical axis represents frequency, the slash-filled region represents a first multicarrier symbol.

In Embodiment 11, when the first multicarrier symbol in the present disclosure is a multicarrier symbol other than an earliest multicarrier symbol in time domain among the M multicarrier symbols in the present disclosure, any multicarrier symbol occupied by K4 RE(s) among the K REs in the present disclosure in time domain is earlier than the first multicarrier symbol in the present disclosure, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence in the present disclosure are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

In one embodiment, the first modulation-symbol group comprises a positive integer number of modulation symbol(s) not less than K5.

In one embodiment, the second modulation-symbol group comprises a positive integer number of modulation symbol(s) not less than K4.

In one embodiment, the first modulation-symbol group only comprises the K5 modulation symbol(s).

In one embodiment, the second modulation-symbol group only comprises the K4 modulation symbol(s).

In one embodiment, the K5 modulation symbol(s) is(are) obtained after that modulation symbol(s) in the first modulation-symbol group is(are) punctured.

In one embodiment, the K4 modulation symbol(s) is(are) obtained after that modulation symbol(s) in the second modulation-symbol group is(are) punctured.

In one embodiment, the K5 modulation symbol(s) is(are) obtained after that modulation symbol(s) in the first modulation-symbol group drops(drop) a positive integer number of modulation symbol(s).

In one embodiment, the K4 modulation symbol(s) is(are) obtained after that modulation symbol(s) in the second modulation-symbol group drops(drop) a positive integer number of modulation symbol(s).

In one embodiment, starting PI modulation symbol(s) in the target modulation-symbol sequence consists(consist) the first modulation-symbol group in order, and any modulation symbol other than the starting PI modulation symbol(s) in the target modulation-symbol sequence consists the second modulation-symbol group, PI being a positive integer not less than K5.

In one embodiment, modulation symbols in the target modulation-symbol sequence are divided into the first modulation-symbol group and the second modulation-symbol group according to index order.

In one embodiment, modulation symbols in the target modulation-symbol sequence are divided into the first modulation-symbol group and the second modulation-symbol group according to channel coding output order.

In one embodiment, modulation symbols in the target modulation sequence are resource mapped onto the K5 RE(s) in order of first frequency and then time starting from the first multicarrier symbol, and subsequently resource mapped onto the K4 RE(s) in order of first frequency and then time starting from an earliest multicarrier symbol among the M multicarrier symbols.

In one embodiment, any modulation symbol in the first modulation-symbol group is resource mapped onto the K5 RE(s) in order of first frequency and then time starting from the first multicarrier symbol, and any modulation symbol in the second modulation symbol group is resource mapped onto the K4 RE(s)in order of first frequency and then time starting from an earliest multicarrier symbol among the M multicarrier symbols.

In one embodiment, the K5 modulation symbol(s) is(are) resource mapped onto the K5 RE(s) in order of first frequency and then time starting from the first multicarrier symbol, and the K4 modulation symbol(s) is(are) resource mapped onto the K4 RE(s) in order of first frequency and then time starting from an earliest multicarrier symbol among the M multicarrier symbols.

### Embodiment 12

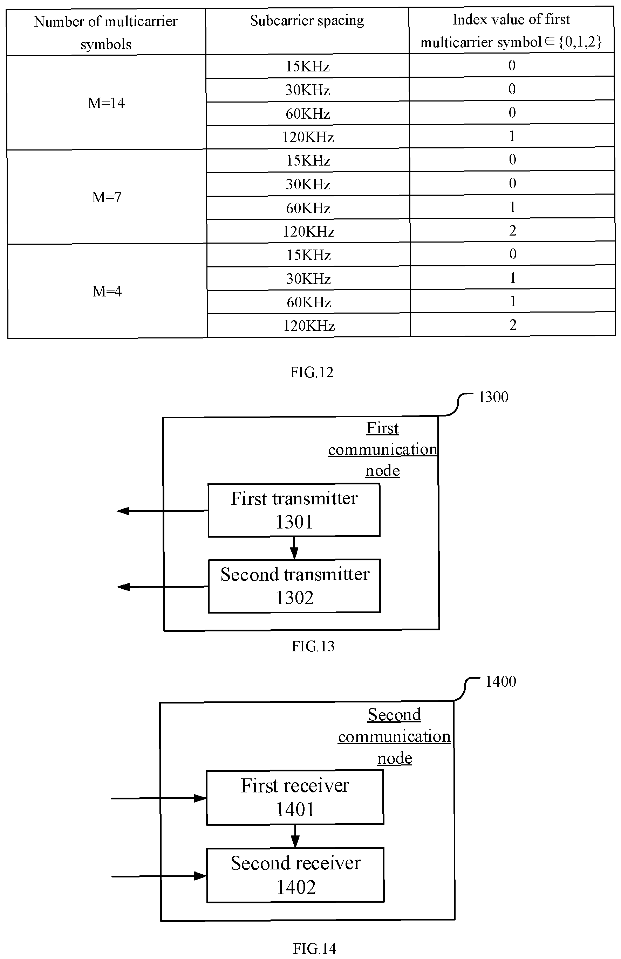

Embodiment 12 illustrates a schematic diagram of relations among an SCS of a subcarrier occupied by K REs, M and index of a first multicarrier symbol according to one embodiment of the present disclosure, as shown in FIG.12. In FIG.12, a first column represents a number M of multicarrier symbols comprised time-domain resources occupied by K REs, the second column represents an SCS of a subcarrier occupied by K REs, and the third column represents an index value of a first multicarrier symbol.

In Embodiment 12, the M multicarrier symbols in the present disclosure are indexed in order of time, an index value of the first multicarrier symbol in the present disclosure among the M multicarrier symbols is one of X1 candidate index value(s);
for given M, an SCS of a subcarrier occupied by the K REs in the present disclosure is one of X2 candidate SCS(s), for each of the X2 candidate SCS(s), there exists one candidate index value in the X1 candidate index value(s) that corresponds to the candidate SCS;
or for a given SCS of a subcarrier occupied by the K REs, M is one of X3 candidate positive integer(s), for each of the X3 candidate positive integer(s), there exists one of the X1 candidate index value(s) that corresponds to the candidate positive integer.

In one embodiment, an index value of the first multicarrier symbol among the M multicarrier symbols increases monotonically with an SCS of a subcarrier occupied by the K REs.

In one embodiment, an index value of the first multicarrier symbol among the M multicarrier symbols increases or stays unchanged with the increase of an SCS of a subcarrier occupied by the K REs.

In one embodiment, an index value of the first multicarrier symbol among the M multicarrier symbols does not decrease with the increase of an SCS of a subcarrier occupied by the K REs.

In one embodiment, an index value of the first multicarrier symbol among the M multicarrier symbols is in linear positive correlation with an SCS of a subcarrier occupied by the K REs.

In one embodiment, an index value of the first multicarrier symbol among the M multicarrier symbols decrease monotonically with M.

In one embodiment, an index value of the first multicarrier symbol among the M multicarrier symbols decreases or remains unchanged with the increase of M.

In one embodiment, an index value of the first multicarrier symbol among the M multicarrier symbols does not increase with the increase of M.

In one embodiment, an index value of the first multicarrier symbol among the M multicarrier symbols is in linear negative correlation with M.

In one embodiment, for given M, the X1 candidate index value(s) is(are) fixed.

In one embodiment, for given M, the X1 candidate index value(s) is(are) predefined.

In one embodiment, for given M, the X1 candidate index value(s) is(are) configured.

In one embodiment, the X1 candidate index value(s) is(are) pre-defined.

In one embodiment, the X1 candidate index value(s) is(are) related to M.

In one embodiment, for given FR of a carrier to which the K REs belong in frequency domain, the X2 candidate SCS(s) is(are) fixed.

In one embodiment, for given FR of a carrier to which the K REs belong in frequency domain, the X2 candidate SCS(s) is(are) pre-defined.

In one embodiment, the X2 candidate SCS(s) is(are) pre-defined.

In one embodiment, the X2 candidate SCS(s) is(are) configured.

In one embodiment, the X2 candidate SCS(s) is(are) fixed.

In one embodiment, the X2 candidate SCSs are respectively 15KHz, 30KHz , 60KHz , 120KHz and 240KHz, X2 being equal to 5.

In one embodiment, the X2 candidate SCSs are respectively 15KHz, 30KHz, 60KHz and 120KHz, X2 being equal to 4.

In one embodiment, a corresponding relation of the X1 candidate index value(s) and the X2 candidate SCS(s) is pre-defined.

In one embodiment, a corresponding relation of the X1 candidate index value(s) and the X2 candidate SCS(s) is configured.

In one embodiment, the X3 candidate positive integer(s) is(are) pre-defined.

In one embodiment, the X3 candidate positive integer(s) is(are) fixed.

In one embodiment, the X3 candidate positive integer(s) is(are) configured.

In one embodiment, the X3 candidate positive integers comprise 2, 4, 7 and 14, X3 being equal to 4.

In one embodiment, the X3 candidate positive integers comprise 2, 4, 7, 14, 28 and 56, X3 being equal to 6.

In one embodiment, a corresponding relation of the X1 candidate index value(s) and the X3 candidate positive integer(s) is pre-defined.

In one embodiment, a corresponding relation of the X1 candidate index value(s) and the X3 candidate positive integer(s) is fixed.

In one embodiment, a corresponding relation of the X1 candidate index value(s) and the X3 candidate positive integer(s) is configured.

### Embodiment 13

Embodiment 13 illustrates a structure diagram of a processing device in a first communication node, as shown in FIG. 13. In FIG. 13, a first communication node processing device 1300 mainly consists of a first transmitter 1301 and a second transmitter 1302. The first transmitter 1301 comprises a transmitter 456 (including an antenna 460), a transmitting processor 455 and a controller/processor 490 in FIG. 4 of the present disclosure; the second transmitter 1302 comprises a transmitter 456 (including an antenna 460), a transmitting processor 455 and a controller/processor 490 in FIG. 4 of the present disclosure.

In Embodiment 13, the first transmitter 1301 transmits first information, the first information is used for indicating K REs, time-domain resources occupied by the K REs comprise M multicarrier symbols, K and M being positive integers greater than 1, the first information is transmitted via an air interface; and the second transmitter 1302 transmits K modulation symbols respectively on the K REs; herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the second transmitter 1302 also transmits a first radio signal; herein, an end time for transmitting the first radio signal is not later than a start time for transmitting the K modulation symbols, and a time interval between an end time for transmitting the first radio signal and a start time for transmitting the K modulation symbols is a first time interval; for a given SCS of a subcarrier occupied by the K REs and given M, a time-domain position of the first multicarrier symbol among the M multicarrier symbols is related to a time length of the first time interval.

In one embodiment, when the first multicarrier symbol is a multicarrier symbol other than an earliest multicarrier symbol in time domain among the M multicarrier symbols, any multicarrier symbol occupied by K3 RE(s) among the K REs in time domain is not earlier than the first multicarrier symbol, K3 being a positive integer less than K; at least one of K3 or a number of multicarrier symbol(s) occupied by the K3 RE(s) is used for determining a number of bit(s) comprised in the first bit block.

In one embodiment, for given the K REs and given M, a number of modulation symbols comprised in the target modulation-symbol sequence is related to a time-domain position of the first multicarrier symbol among the M multicarrier symbols.

In one embodiment, when the first multicarrier symbol is a multicarrier symbol other than an earliest multicarrier symbol in time domain among the M multicarrier symbols, there exist a first RE and a second RE among the K REs, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a modulation symbol occupying the first RE among the K modulation symbols is the same as a modulation symbol occupying the second RE among the K modulation symbols.

In one embodiment, when the first multicarrier symbol is a multicarrier symbol other than an earliest multicarrier symbol in time domain among the M multicarrier symbols, any multicarrier symbol occupied by K4 RE(s) among the K REs in time domain is earlier than the first multicarrier symbol, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

In one embodiment, the M multicarrier symbols are indexed in order of time, an index value of the first multicarrier symbol among the M multicarrier symbols is one of X1 candidate index value(s);
for given M, an SCS of a subcarrier occupied by the K REs is one of X2 candidate SCS(s), for each of the X2 candidate SCS(s), there exists one candidate index value in the X1 candidate index value(s) that corresponds to the candidate SCS;
or for a given SCS of a subcarrier occupied by the K REs, M is one of X3 candidate positive integer(s), for each of the X3 candidate positive integer(s), there exists one of the X1 candidate index value(s) that corresponds to the candidate positive integer.

### Embodiment 14

Embodiment 14 illustrates a structure block diagram of a processing device of a second communication node according to one embodiment, as shown in FIG. 14. In FIG. 14, the second communication node processing device 1400 mainly consists of a first receiver 1401 and a second receiver 1402. The first receiver 1401 comprises a transmitter/receiver 416 (including an antenna 420), a receiving processor 412 and a controller/processor 440 in FIG. 4 of the present disclosure. The second receiver 1402 comprises a transmitter/receiver 416 (including an antenna 420), a receiving processor 412 and a controller/processor 440 in FIG. 4 of the present disclosure.

In Embodiment 14, the first receiver 1401 receives first information, the first information is used for indicating K REs, time-domain resources occupied by the K REs comprise M multicarrier symbols, K and M being positive integers greater than 1, the first information is transmitted via an air interface; and the second receiver 1402 receives K modulation symbols respectively on the K REs; herein, a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

In one embodiment, the second receiver 1402 also receives a first radio signal; herein, an end time for transmitting the first radio signal is not later than a start time for transmitting the K modulation symbols, and a time interval between an end time for transmitting the first radio signal and a start time for transmitting the K modulation symbols is a first time interval; for a given SCS of a subcarrier occupied by the K REs and given M, a time-domain position of the first multicarrier symbol among the M multicarrier symbols is related to a time length of the first time interval.

In one embodiment, when the first multicarrier symbol is a multicarrier symbol other than an earliest multicarrier symbol in time domain among the M multicarrier symbols, any multicarrier symbol occupied by K3 RE(s) among the K REs in time domain is not earlier than the first multicarrier symbol, K3 being a positive integer less than K; at least one of K3 or a number of multicarrier symbol(s) occupied by the K3 RE(s) is used for determining a number of bit(s) comprised in the first bit block.

In one embodiment, for given the K REs and given M, a number of modulation symbols comprised in the target modulation-symbol sequence is related to a time-domain position of the first multicarrier symbol among the M multicarrier symbols.

In one embodiment, when the first multicarrier symbol is a multicarrier symbol other than an earliest multicarrier symbol in time domain among the M multicarrier symbols, there exist a first RE and a second RE among the K REs, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a modulation symbol occupying the first RE among the K modulation symbols is the same as a modulation symbol occupying the second RE among the K modulation symbols.

In one embodiment, when the first multicarrier symbol is a multicarrier symbol other than an earliest multicarrier symbol in time domain among the M multicarrier symbols, any multicarrier symbol occupied by K4 RE among the K REs in time domain is earlier than the first multicarrier symbol, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

In one embodiment, the M multicarrier symbols are indexed in order of time, an index value of the first multicarrier symbol among the M multicarrier symbols is one of X1 candidate index value(s);
for given M, an SCS of a subcarrier occupied by the K REs is one of X2 candidate SCS(s), for each of the X2 candidate SCS(s), there exists one of the X1 candidate index value(s) that corresponds to the candidate SCS;
or for a given SCS of a subcarrier occupied by the K REs, the M is one of X3 candidate positive integer(s), for each of the X3 candidate positive integer(s), there exists of the X1 candidate index value(s) that corresponds to the candidate positive integer.

The ordinary skill in the art may understand that all or part of steps in the above method may be implemented by instructing related hardware through a program. The program may be stored in a computer readable storage medium, for example Read-Only Memory (ROM), hard disk or compact disc, etc. Optionally, all or part of steps in the above embodiments also may be implemented by one or more integrated circuits. Correspondingly, each module unit in the above embodiment may be realized in the form of hardware, or in the form of software function modules. The first communication node, the second communication node, the UE, or the terminal in the present disclosure includes but is not limited to mobile phones, tablet computers, notebooks, network cards, low-consumption equipment, enhanced MTC (eMTC) terminals, NB-IoT terminals, vehicle-mounted communication equipment, Road Side Unit(RSU), aircrafts, diminutive airplanes, unmanned aerial vehicles, tele-controlled aircrafts and other wireless communication devices. The first communication node in the present disclosure also includes but is not limited to base station or network side device, and includes but is not limited to the macro-cellular base stations, micro-cellular base stations, home base stations, relay base station, eNB, gNB, Transmitter Receiver Point(TRP) and other radio communication equipment.

The above are merely the preferred embodiments of the present disclosure and are not intended to limit the scope of protection of the present disclosure. Any modification, equivalent substitute and improvement made within the spirit and principle of the present disclosure are intended to be included within the scope of protection of the present disclosure.

## Claims

1. A method in a first communication node for wireless communications, comprising:
transmitting first information, the first information being used for indicating K Resource Elements(REs), time-domain resources occupied by the K REs comprising M multicarrier symbols, K and M being positive integers greater than 1, the first information being transmitted via an air interface; and
transmitting K modulation symbols respectively on the K REs;
wherein a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of a Subcarrier Spacing(SCS) of a subcarrier occupied by the K REs or M, or the first information is used for indicating a time-domain position of the first multicarrier symbol among the M multicarrier symbols.

2. The method according claim 1, comprising:
transmitting a first radio signal;
wherein an end time for transmitting the first radio signal is not later than a start time for transmitting the K modulation symbols, and a time interval between an end time for transmitting the first radio signal and a start time for transmitting the K modulation symbols is a first time interval; for a given SCS of a subcarrier occupied by the K REs and given M, a time-domain position of the first multicarrier symbol among the M multicarrier symbols is related to a time length of the first time interval.

3. The method according to any of claim 1 or 2, wherein if the first multicarrier symbol is a multicarrier symbol other than an earliest multicarrier symbol among the M multicarrier symbols in time domain, any multicarrier symbol occupied by K3 RE(s) among the K REs in time domain is not earlier than the first multicarrier symbol, K3 being a positive integer less than K; at least one of K3 or a number of multicarrier symbol(s) occupied by the K3 RE(s) is used for determining a number of bit(s) comprised in the first bit block.

4. The method according to any of claims 1 to 3, wherein for given the K REs and given M, a number of modulation symbols comprised in the target modulation-symbol sequence is related to a time-domain position of the first multicarrier symbol among the M multicarrier symbols.

5. The method according to any of claims 1 to 4, wherein if the first multicarrier symbol is a multicarrier symbol other than an earliest multicarrier symbol in time domain among the M multicarrier symbols, there exist a first RE and a second RE among the K REs, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a modulation symbol occupying the first RE among the K modulation symbols is the same as a modulation symbol occupying the second RE among the K modulation symbols.

6. The method according to any of claims 1 to 4, wherein if the first multicarrier symbol is a multicarrier symbol other than an earliest multicarrier symbol in time domain among the M multicarrier symbols, any multicarrier symbol occupied by K4 RE(s) among the K REs in time domain is earlier than the first multicarrier symbol, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

7. The method according to any of claims 1 to 6, wherein the M multicarrier symbols are indexed in order of time, an index value of the first multicarrier symbol among the M multicarrier symbols is one of X1 candidate index value(s);
for given M, an SCS of a subcarrier occupied by the K REs is one of X2 candidate SCS(s), for each of the X2 candidate SCS(s), there exists one of the X1 candidate index value(s) that corresponds to the candidate SCS;
or for a given SCS of a subcarrier occupied by the K REs, M is one of X3 candidate positive integer(s), for each of the X3 candidate positive integer(s), there exists one of the X1 candidate index value(s) that corresponds to the candidate positive integer.

8. A method in a second communication node for wireless communications, comprising:
receiving first information, the first information being used for indicating K REs, time-domain resources occupied by the K REs comprising M multicarrier symbols, K and M being positive integers greater than 1, the first information being transmitted via an air interface; and
receiving K modulation symbols respectively on the K REs;
wherein a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

9. The method according to claim 1, comprising:
receiving a first radio signal;
wherein an end time for transmitting the first radio signal is not later than a start time for transmitting the K modulation symbols, and a time interval between an end time for transmitting the first radio signal and a start time for transmitting the K modulation symbols is a first time interval; for a given SCS of a subcarrier occupied by the K REs and given M, a time-domain position of the first multicarrier symbol among the M multicarrier symbols is related to a time length of the first time interval.

10. The method according any of claim 8 or 9, wherein if the first multicarrier symbol is a multicarrier symbol other than an earliest multicarrier symbol in time domain among the M multicarrier symbols, any multicarrier symbol occupied by K3 RE(s) among the K REs in time domain is not earlier than the first multicarrier symbol, K3 being a positive integer less than K; at least one of K3 or a number of multicarrier symbol(s) occupied by the K3 RE(s) is used for determining a number of bit(s) comprised in the first bit block.

11. The method according to any of claims 8 to 10, wherein for given the K REs and given M, a number of modulation symbols comprised in the target modulation-symbol sequence is related to a time-domain position of the first multicarrier symbol among the M multicarrier symbols.

12. The method according to any of claims 8 to 11, wherein if the first multicarrier symbol is a multicarrier symbol other than an earliest multicarrier symbol in time domain among the M multicarrier symbols, there exist a first RE and a second RE among the K REs, a multicarrier symbol occupied by the first RE in time domain is one of the M multicarrier symbols earlier than the first multicarrier symbol, a multicarrier symbol occupied by the second RE in time domain is one of the M multicarrier symbols not earlier than the first multicarrier symbol; and a multicarrier symbol occupying the first RE among the K modulation symbols is the same as a multicarrier symbol occupying the second RE among the K modulation symbols.

13. The method according to any of claims 8 to 11, wherein if the first multicarrier symbol is a multicarrier symbol other than an earliest multicarrier symbol in time domain among the M multicarrier symbols, any multicarrier symbol occupied by K4 RE(s) among the K REs in time domain is earlier than the first multicarrier symbol, any multicarrier symbol occupied by K5 RE(s) among the K REs in time domain is not earlier than the first multicarrier symbol, a sum of K4 and K5 is equal to K, K4 and K5 being positive integers; modulation symbols in the target modulation-symbol sequence are divided into a first modulation-symbol group and a second modulation-symbol group in order, any of K4 modulation symbol(s) occupying the K4 RE(s) among the K modulation symbols belongs to the second modulation-symbol group, and any of K5 modulation symbol(s) occupying the K5 RE(s) among the K modulation symbols belongs to the first modulation-symbol group.

14. The method according to claims 8 to 13, wherein the M multicarrier symbols are indexed in order of time, an index value of the first multicarrier symbol among the M multicarrier symbols is one of X1 candidate index value(s);
for given M, an SCS of a subcarrier occupied by the K REs is one of X2 candidate SCS(s), for each of the X2 candidate SCS(s), there exists one of the X1 candidate index value(s) that corresponds to the candidate SCS;
or for a given SCS of a subcarrier occupied by the K REs, M is one of X3 candidate positive integer(s), for each of the X3 candidate positive integer(s), there exists one of the X1 candidate index value(s) that corresponds to the candidate positive integer.

15. A first communication node for wireless communications, comprising:
a first transmitter, transmitting first information, the first information being used for indicating K REs, time-domain resources occupied by the K REs comprising M multicarrier symbols, K and M being positive integers greater than 1, the first information being transmitted via an air interface; and
a second transmitter, transmitting K modulation symbols respectively on the K REs;
wherein a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.

16. A second node for wireless communications, comprising:
a first receiver, receiving first information, the first information being used for indicating K REs, time-domain resources occupied by the K REs comprising M multicarrier symbols, K and M being positive integers greater than 1, the first information being transmitted via an air interface; and
a second receiver, receiving K modulation symbols respectively on the K REs;
wherein a first multicarrier symbol is one of the M multicarrier symbols, K1 modulation symbol(s) comprises(comprise) modulation symbol(s) among the K modulation symbols that is(are) mapped onto the first multicarrier symbol, K1 being a positive integer; an output of a first bit block through channel coding is used for generating a target modulation-symbol sequence, each of the K modulation symbols belongs to the target modulation-symbol sequence, and the first bit block comprises a positive integer number of bit(s); starting K2 modulation symbol(s) in the target modulation-symbol sequence comprises(comprise) the K1 modulation symbol(s), K2 being a positive integer not less than K1; a time-domain position of the first multicarrier symbol among the M multicarrier symbols is related to at least one of an SCS of a subcarrier occupied by the K REs or M, or the first information is used for indicating a time-domain position of the first multicarrier symbol among the M multicarrier symbols.
